(19) **Europäisches Patentamt**
**European Patent Office**
**Office européen des brevets**

(11) **EP 4 529 058 A1**

(12) **EUROPEAN PATENT APPLICATION**
published in accordance with Art. 153(4) EPC

(43) Date of publication:
**26.03.2025 Bulletin 2025/13**

(21) Application number: **23825996.4**

(22) Date of filing: **09.05.2023**

(51) International Patent Classification (IPC):
**H04L 1/00** (2006.01)

(52) Cooperative Patent Classification (CPC):
**H04L 1/00**

(86) International application number:
**PCT/CN2023/093000**

(87) International publication number:
**WO 2023/246346 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.06.2022 CN 202210731905**

(71) Applicant: **Huawei Technologies Co., Ltd.**
**Shenzhen, Guangdong 518129 (CN)**

(72) Inventors:
• **YAN, Zengchao**
**Shenzhen, Guangdong 518129 (CN)**
• **MA, Huixiao**
**Shenzhen, Guangdong 518129 (CN)**
• **HUANG, Kechao**
**Shenzhen, Guangdong 518129 (CN)**
• **YANG, Xiaoling**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **DATA TRANSMISSION APPARATUS**

(57) A data transmission apparatus is provided, to resolve a problem that implementing a low delay and meeting transmission performance cannot be both implemented in an interleaving process in a conventional technology. The data transmission apparatus may be used in fields such as short-distance interconnection, cloud application, augmented reality AR, virtual reality VR, and artificial intelligence AI. The data transmission apparatus includes z physical coding sublayer PCS lanes and z convolutional interleaving modules, one convolutional interleaving module corresponds to one PCS lane, the convolutional interleaving module includes x levels of cascaded convolutional interleavers, x is an integer greater than 1, and z is a positive integer. The PCS lane is configured to receive a first data stream from a PCS, where one first data stream corresponds to one PCS lane. The convolutional interleaving module is configured to perform interleaving processing on a first data stream from a corresponding PCS lane, to obtain a second data stream, where an interleaving depth of the second data stream is related to a quantity of input bits of an inner-code encoder. Based on cascaded interleavers, a quantity of levels of the cascaded interleavers can be flexibly selected.

FIG. 5

**Description**

CROSS-REFERENCE TO RELATED APPLICATIONS

This application claims priority to Chinese Patent Application No. 202210731905.0, filed with the China National Intellectual Property Administration on June 25, 2022 and entitled "DATA TRANSMISSION APPARATUS", which is incorporated herein by reference in its entirety.

TECHNICAL FIELD

This application relates to the field of communication technologies, and in particular, to a data transmission apparatus.

BACKGROUND

With continuous and high-speed growth of data traffic, a device capacity is also rapidly increasing, and a requirement on an Ethernet transmission rate is increasingly high. The international organization for standardization defines the institute of electrical and electronics engineers (institute of electrical and electronics engineers, IEEE) 802.3 Ethernet (Ethernet) protocol. The IEEE 802.3 Ethernet protocol defines 100 gigabit Ethernet (GE), 200GE, and 400GE interface protocols. However, a 400GE network port technology also has been incapable of satisfying a requirement, and a next-generation Ethernet technology with a throughput rate more than 400 gigabits per second (Gigabits per second, Gbps) (for example, 800 Gbps or 1.6 Tbps) is urgently needed.

However, as the Ethernet transmission rate increases, a transmission bit error rate also increases, and a forward error correction (forward error correction, FEC) code becomes a key technology for avoiding a transmission bit error. How to design a low-delay interleaver that can meet transmission performance is a technical problem that urgently needs to be resolved currently.

SUMMARY

This application provides a data transmission apparatus, to meet transmission performance of a data stream and help reduce a transmission delay of the data stream.

According to a first aspect, this application provides a data transmission apparatus. The data transmission apparatus includes z physical coding sublayer (physical coding sublayer, PCS) lanes and z convolutional interleaving modules, where one convolutional interleaving module corresponds to one PCS lane, the convolutional interleaving module includes x levels of cascaded convolutional interleavers, x is an integer greater than 1, and z is a positive integer. The PCS lane is configured to receive a first data stream from a PCS, where one first data stream corresponds to one PCS lane. The convolutional interleaving module is configured to perform interleaving processing on a first data stream from a corresponding PCS lane, to obtain a second data stream, where an interleaving depth of the second data stream is related to a quantity of input bits of an inner-code encoder.

Based on the foregoing data transmission apparatus, a plurality of convolutional interleavers are cascaded, so that a quantity of levels of cascaded interleavers can be flexibly selected, thereby meeting transmission performance of a data stream and helping reduce a transmission delay of the data stream.

In a possible implementation, the convolutional interleaving module is specifically configured to perform interleaving processing on the first data stream from the corresponding PCS lane based on a received indication signal. The indication signal indicates to bypass at least one level of convolutional interleaver in the z convolutional interleaving modules. Alternatively, the indication signal indicates to bypass a $j^{th}$ level of convolutional interleaver in an $i^{th}$ convolutional interleaving module in the z convolutional interleaving modules, where i is an integer less than z, and j is an integer less than x.

Based on the indication signal, bypassing of one or more specific levels of convolutional interleavers in the z convolutional interleaving modules may be flexibly controlled, so that a bit width of the inner-code encoder does not need to be limited, and the inner-code encoder can further be flexibly selected. Alternatively, a quantity of levels of cascaded convolutional interleavers in each convolutional interleaving module may be independently controlled, so that different PCS lanes have different error correction capabilities. This helps further increase applicable scenarios. For example, a breakout (Breakout) transmission mode may be supported.

In a possible implementation, the apparatus further includes a management data input/output (management data input/output, MDIO) interface, and the indication signal includes a value of an MDIO control bit. The MDIO interface is configured to receive first information, where the first information includes the value of the MDIO control variable, and the MDIO control variable is mapped to a control variable of the x levels of convolutional interleavers.

Transmission of the indication signal is performed through the MDIO interface, so that bandwidth for communicating the data stream may not be occupied.

In a possible implementation, the apparatus further includes an attachment unit interface (attachment unit interface, AUI), and the indication signal includes a first preset sequence or a second preset sequence. The AUI is configured to: receive an alignment marker (alignment marker, AM) sequence from the corresponding PCS lane, where the AM sequence includes the first preset sequence; or receive the second preset sequence from the corresponding PCS lane.

The indication signal is carried in the AM sequence, to help reduce overheads between an optical module and a device.

**In** a possible implementation, a quantity of symbols input into a sub-lane of a $k^{th}$ level of convolutional interleaver is equal to a quantity of symbols output from the sub-lane of the $k^{th}$ level of convolutional interleaver, the $k^{th}$ level of convolutional interleaver is any one of x convolutional interleavers in a first convolutional interleaving module, the first convolutional interleaving module is any one of the z convolutional interleaving modules, and k is a positive integer less than or equal to x.

Further, optionally, an input interleaving depth of the first convolutional interleaving module is related to a coding scheme of the PCS and a symbol distribution manner, and an output interleaving depth of the first convolutional interleaving module is $w_x \times p_x$, where $w_x$ is a quantity of symbols input into a sub-lane of an $x^{th}$ level of convolutional interleaver in the first convolutional interleaving module, and $p_x$ is a quantity of sub-lanes included in the $x^{th}$ level of convolutional interleaver in the first convolutional interleaving module.

In a possible implementation, when k is a positive integer greater than 1 and less than or equal to x, an input interleaving depth of the $k^{th}$ level of convolutional interleaver is $w_{k-1} \times p_{k-1}$, and an output interleaving depth of the $k^{th}$ level of convolutional interleaver is $w_k \times p_k$, where $w_k$ is the quantity of symbols input into the sub-lane of the $k^{th}$ level of convolutional interleaver, $p_k$ is a quantity of sub-lanes included in the $k^{th}$ level of convolutional interleaver, $w_{k-1}$ is a quantity of symbols input into a sub-lane of a $(k-1)^{th}$ level of convolutional interleaver, and $p_{k-1}$ is a quantity of sub-lanes included in the $(k-1)^{th}$ level of convolutional interleaver. An input interleaving depth of a $1^{st}$ level of convolutional interleaver in the first convolutional interleaving module is equal to the input interleaving depth of the first convolutional interleaving module.

In a possible implementation, when k is a positive integer greater than 1 and less than or equal to x, delays of the $k^{th}$ level of convolutional interleaver and the $1^{st}$ level of convolutional interleaver satisfy Formula 1 below:

$$\Delta_k \geq \left\lceil \frac{p_1}{p_k} \times \frac{w_k}{w_1} \right\rceil \times \Delta_1 \quad \text{Formula 1}$$

$w_k$ is the quantity of symbols input into the sub-lane of the $k^{th}$ level of convolutional interleaver, $p_k$ is the quantity of sub-lanes included in the $k^{th}$ level of convolutional interleaver, $w_1$ is a quantity of symbols input into a sub-lane of the $1^{st}$ level of convolutional interleaver, $p_1$ is a quantity of sub-lanes included in the $1^{st}$ level of convolutional interleaver, and $\Delta_1$ is a delay between two adjacent sub-lanes in the $1^{st}$ level of convolutional interleaver.

According to Formula 1 above, a delay relationship between the $1^{st}$ level of convolutional interleaver and a level of convolutional interleaver other than the $1^{st}$ level of convolutional interleaver may be obtained. In addition, it can be ensured that an interleaving depth increases as levels of cascaded convolutional interleavers increase.

For example, the delays of the $k^{th}$ level of convolutional interleaver and the $1^{st}$ level of convolutional interleaver satisfy Formula 2 below:

$$\Delta_k = \left\lceil \frac{p_1}{p_k} \right\rceil \times \left\lceil \frac{w_k}{w_1} \right\rceil \times \Delta_1 \quad \text{Formula 2}$$

According to Formula 2 above, a delay of the level of convolutional interleaver other than the $1^{st}$ level of convolutional interleaver may be obtained in a simple design.

In a possible implementation, the delay $\Delta_1$ between the two adjacent sub-lanes in the $1^{st}$ level of convolutional interleaver is an integer multiple of the input interleaving depth of the first convolutional interleaving module, and satisfies Formula 3 below:

$$\Delta_1 > \left\lceil \frac{L}{P1} \right\rceil \quad \text{Formula 3}$$

L is a quantity of symbols allocated to a PCS lane corresponding to the first convolutional interleaving module.

According to Formula 3 above, an output interleaving depth of the $1^{st}$ level of convolutional interleaver can be increased.

In a possible implementation, quantities of sub-lanes of the x levels of convolutional interleavers included in the first convolutional interleaving module are different, and the first convolutional interleaving module is any one of the z convolutional interleaving modules.

Further, optionally, a quantity of sub-lanes of the 1st level of convolutional interleaver included in the first convolutional interleaving module is different from quantities of sub-lanes of (x-1) levels of convolutional interleavers other than the 1st level of convolutional interleaver included in the first convolutional interleaving module, and the quantities of sub-lanes of the (x-1) levels of convolutional interleavers other than the 1st level of convolutional interleaver included in the first convolutional interleaving module are the same.

For example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 24 symbols, and/or a delay of the 2nd level of convolutional interleaver is 144 symbols.

For another example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 24 symbols, and/or a delay of the 2nd level of convolutional interleaver is 120 symbols.

For another example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 26 symbols, and/or a delay of the 2nd level of convolutional interleaver is 130 symbols.

For another example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 26 symbols, and/or a delay of the 2nd level of convolutional interleaver is 156 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 24 symbols, and/or a delay of the 2nd level of convolutional interleaver is 120 symbols, and/or a delay of the 3rd level of convolutional interleaver is 216 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 24 symbols, and/or a delay of the 2nd level of convolutional interleaver is 144 symbols, and/or a delay of the 2nd level of convolutional interleaver is 288 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 26 symbols, and/or a delay of the 2nd level of convolutional interleaver is 130 symbols, and/or a delay of the 3rd level of convolutional interleaver is 234 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 24 symbols, and/or a delay of the 2nd level of convolutional interleaver is 120 symbols, and/or a delay of the 3rd level of convolutional interleaver is 240 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 26 symbols, and/or a delay of the 2nd level of convolutional interleaver is 130 symbols, and/or a delay of the 3rd level of convolutional interleaver is 260 symbols.

For another example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 46 symbols, and/or a delay of the 2nd level of convolutional interleaver is 230 symbols.

For another example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 46 symbols, and/or a delay of the 2nd level of convolutional interleaver is 276 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 46 symbols, and/or a delay of the 2nd level of convolutional interleaver is 230 symbols, and/or a delay of the 3rd level of convolutional interleaver is 414 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 46 symbols, and/or a delay of the 2nd level of convolutional interleaver is 276 symbols, and/or a delay of the 3rd level of convolutional interleaver is 552 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 48 symbols, and/or a delay of the 2nd level of convolutional interleaver is 240 symbols, and/or a delay of the 3rd level of convolutional interleaver is 432 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 48 symbols, and/or a delay of the 2nd level of convolutional interleaver is 288 symbols, and/or a delay of the 3rd level of convolutional interleaver is 576 symbols.

In a possible implementation, the 1st level of convolutional interleaver includes three sub-lanes, and each of the included (x-1) levels of convolutional interleavers other than the 1st level of convolutional interleaver includes two sub-lanes. Delays of two adjacent levels of convolutional interleavers in the included (x-1) levels of convolutional interleavers other than the 1st level of convolutional interleaver satisfy Formula 4 below:

$$\Delta_k = 2 \times \Delta_{k-1} = 2^{k-1} \times 3 \times \Delta_1 \quad \text{Formula 4}$$

$\Delta_{k-1}$ is a delay of the (k-1)th level of interleaver, and $\Delta_1$ is the delay between the two adjacent sub-lanes in the 1st level of convolutional interleaver.

In a possible implementation, quantities of sub-lanes included in the x levels of convolutional interleavers included in the first convolutional interleaving module are the same, and the first convolutional interleaving module is any one of the z convolutional interleaving modules.

For example, the first convolutional interleaving module includes the 1st level of convolutional interleaver and a 2nd level of convolutional interleaver, and the first convolutional interleaving module is any one of the z convolutional interleaving modules. A delay between the two adjacent sub-lanes in the 1st level of convolutional interleaver is 36 symbols, and/or a delay of the 2nd level of convolutional interleaver is 72 symbols.

In a possible implementation, quantities of sub-lanes included in the x levels of convolutional interleavers included in the first convolutional interleaving module are the same.

In a possible implementation, each of the x levels of convolutional interleavers includes two sub-lanes, and delays of two adjacent levels of convolutional interleavers in the x levels of convolutional interleavers satisfy Formula 5 below:

$$\Delta_k = 2 \times \Delta_{k-1} = 2^{k-1} \times \Delta_1 \quad \text{Formula 5}$$

$\Delta_{k-1}$ is a delay of the (k-1)th level of interleaver.

For example, the first convolutional interleaving module includes the 1st level of convolutional interleaver and a 2nd level of convolutional interleaver, and the first convolutional interleaving module is any one of the z convolutional interleaving modules. The delay between the two adjacent sub-lanes in the 1st level of convolutional interleaver is 36 symbols, and/or a delay of the 2nd level of convolutional interleaver is 72 symbols.

For example, the first convolutional interleaving module includes the 1st level of convolutional interleaver and a 2nd level of convolutional interleaver. The delay between the two adjacent sub-lanes in the 1st level of convolutional interleaver is 34 symbols, and/or a delay of the 2nd level of convolutional interleaver is 68 symbols.

For example, the first convolutional interleaving module includes the 1st level of convolutional interleaver and a 2nd level of convolutional interleaver. The delay between the two adjacent sub-lanes in the 1st level of convolutional interleaver is 38 symbols, and/or a delay of the 2nd level of convolutional interleaver is 76 symbols.

For example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 34 symbols, and/or a delay of the 2nd level of convolutional interleaver is 68 symbols, and/or a delay of the 3rd level of convolutional interleaver is 136 symbols.

For example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 68 symbols, and/or a delay of the 2nd level of convolutional interleaver is 136 symbols, and/or a delay of the 3rd level of convolutional interleaver is 272 symbols.

For example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 70 symbols, and/or a delay of the 2nd level of convolutional interleaver is 140 symbols, and/or a delay of the 3rd level of convolutional interleaver is 280 symbols.

For another example, the first convolutional interleaving module includes the 1st level of convolutional interleaver, a 2nd level of convolutional interleaver, and a 3rd level of convolutional interleaver, and the first convolutional interleaving module is any one of the z convolutional interleaving modules. The delay between the two adjacent sub-lanes in the 1st level of convolutional interleaver is 72 symbols, and/or a delay of the 2nd level of convolutional interleaver is 144 symbols, and/or a delay of the 3rd level of convolutional interleaver is 288 symbols.

In a possible implementation, quantities of symbols input into sub-lanes of x levels of convolutional interleavers included in a first convolutional interleaving module are the same, quantities of symbols output from the sub-lanes of the x levels of convolutional interleavers included in the first convolutional interleaving module are the same, and a quantity of symbols input into a sub-lane of a $k^{th}$ level of convolutional interleaver is greater than a quantity of symbols output from the sub-lane of the $k^{th}$ level of convolutional interleaver, where the $k^{th}$ level of convolutional interleaver is any one of the x convolutional interleavers in the first convolutional interleaving module, the first convolutional interleaving module is any one of the z convolutional interleaving modules, and k is a positive integer less than or equal to x.

In a possible implementation, an input interleaving depth of the first convolutional interleaving module is related to a coding scheme of the PCS and a symbol distribution manner. An output interleaving depth of the first convolutional interleaving module is the interleaving depth$\times p_1\times...p_{x-1}\times p_x$, where $p_1$ is a quantity of sub-lanes included in a 1st level of convolutional interleaver in the first convolutional interleaving module, $p_{x-1}$ is a quantity of sub-lanes included in an $(x-1)^{th}$ level of convolutional interleaver in the first convolutional interleaving module, and $p_x$ is a quantity of sub-lanes included in an $x^{th}$ level of convolutional interleaver in the first convolutional interleaving module.

In a possible implementation, a quantity of symbols input into a sub-lane of the $x^{th}$ level of convolutional interleaver is obtained based on the quantity of sub-lanes of the $x^{th}$ level of convolutional interleaver and a maximum output interleaving depth of the first convolutional interleaving module. A quantity of symbols output from the sub-lane of the $x^{th}$ level of convolutional interleaver is obtained based on the input interleaving depth of the first convolutional interleaving module.

In a possible implementation, the quantity of symbols input into the sub-lane of the $x^{th}$ level of convolutional interleaver is equal to the maximum output interleaving depth of the first convolutional interleaving module divided by the quantity of sub-lanes of the $x^{th}$ level of convolutional interleaver. The quantity of symbols output from the sub-lane of the $x^{th}$ level of convolutional interleaver is equal to the input interleaving depth of the first convolutional interleaving module.

In a possible implementation, the quantities of symbols input into the sub-lanes of the x levels of convolutional interleavers and the quantities of symbols output from the sub-lanes of the x levels of convolutional interleavers are any one of the following: The quantities of symbols input into the sub-lanes of the x levels of convolutional interleavers each are 8, and the quantities of symbols output from the sub-lanes of the x levels of convolutional interleavers each are 2. Alternatively, the quantities of symbols input into the sub-lanes of the x levels of convolutional interleavers each are 6, and the quantities of symbols output from the sub-lanes of the x levels of convolutional interleavers each are 2. Alternatively, the quantities of symbols input into the sub-lanes of the x levels of convolutional interleavers each are 4, and the quantities of symbols output from the sub-lanes of the x levels of convolutional interleavers each are 2. Alternatively, the quantities of symbols input into the sub-lanes of the x levels of convolutional interleavers each are 8, and the quantities of symbols output from the sub-lanes of the x levels of convolutional interleavers each are 1. Alternatively, the quantities of symbols input into the sub-lanes of the x levels of convolutional interleavers each are 6, and the quantities of symbols output from the sub-lanes of the x levels of convolutional interleavers each are 1. Alternatively, the quantities of symbols input into the sub-lanes of the x levels of convolutional interleavers each are 4, and the quantities of symbols output from the sub-lanes of the x levels of convolutional interleavers each are 1.

In a possible implementation, the apparatus further includes an AM lock module, and the AM lock module is configured to align a boundary of a symbol in the first data stream.

In a possible implementation, the apparatus further includes an inner-code encoding module, and the inner-code encoding module is configured to encode the second data stream.

According to a second aspect, this application provides an optical module. The optical module may include the data transmission apparatus in any one of the first aspect or the possible implementations of the first aspect.

For technical effects that can be achieved in the second aspect, refer to descriptions of beneficial effects in the first aspect. Details are not described herein again.

BRIEF DESCRIPTION OF DRAWINGS

FIG. 1a is a diagram of an architecture of a data center to which this application may be applied;

FIG. 1b is a diagram of an architecture of another data center to which this application may be applied;

FIG. 2a is a diagram of a structure of an optical module according to this application;

FIG. 2b is a diagram of a structure of another optical module according to this application;

FIG. 3 is a diagram of a structure of a device according to this application;

FIG. 4 is a diagram of communication between an optical module and a device according to this application;

FIG. 5 is a diagram of a structure of a data transmission apparatus according to this application;

FIG. 6a is a diagram of a structure of z convolutional interleaving modules according to this application;

FIG. 6b is a diagram of a structure of other z convolutional interleaving modules according to this application;

FIG. 7a is a diagram of a structure of other z convolutional interleaving modules according to this application;

FIG. 7b is a diagram of a structure of other z convolutional interleaving modules according to this application;

FIG. 8 is a diagram of a structure of a $k^{th}$ level of convolutional interleaver according to this application;

FIG. 9 is a diagram of a structure of a first convolutional interleaving module according to this application;

FIG. 10 is a diagram of a structure of a first convolutional interleaving module according to this application;

FIG. 11 is a diagram of a structure of another first convolutional interleaving module according to this application;

FIG. 12 is a diagram of a structure of another first convolutional interleaving module according to this application;

FIG. 13 is a diagram of a structure of another first convolutional interleaving module according to this application;

FIG. 14 is a diagram of a structure of another $k^{th}$ level of convolutional interleaver according to this application;

FIG. 15 is a diagram of a structure of another first convolutional interleaving module according to this application;

FIG. 16 is a diagram of a structure of another first convolutional interleaving module according to this application;

FIG. 17 is a diagram of a structure of another first convolutional interleaving module according to this application; and

FIG. 18 is a diagram of a structure of another first convolutional interleaving module according to this application.

DESCRIPTION OF EMBODIMENTS

The following describes in detail embodiments of this application with reference to accompanying drawings.

Some terms in this application are described below. It should be noted that these explanations are for ease of understanding by a person skilled in the art, and are not intended to limit the protection scope claimed in this application.

1. Relationship between a codeword and a symbol

A PCS in an 800G-Ethernet technology consortium (Ethernet technology consortium, ETC) mode is used as an example. Each PCS includes four Reed-Solomon (Reed-Solomon, RS) codewords, the RS codeword is indicated as KP4 (544, 514), and KP4 (544, 514) indicates that one codeword includes 544 symbols. The PCS in the 800G-ETC mode has 32 PCS lanes in total. Every two RS codewords form one group. Codewords in a first group are indicated as an RS codeword A and an RS codeword B, codewords in a second group are indicated as an RS codeword C and an RS codeword D, and codewords in a third group are indicated as an RS codeword E and an RS codeword F. A symbol of the RS codeword A is indicated as a symbol a, a symbol of the RS codeword B is indicated as a symbol b, a symbol of the RS codeword C is indicated as a symbol c, a symbol of the RS codeword D is indicated as a symbol d, a symbol of the RS codeword E is indicated as a symbol e, and a symbol of the RS codeword F is indicated as a symbol f. One group of RS codewords is allocated to 16 PCS lanes. One group of RS codewords is used as an example. $2 \times 544/16 = 68$ symbols may be allocated to each PCS lane, and two symbols are interleaved on each lane. Specifically, the codewords in the first group (the RS codeword A and the RS codeword B) are used as an example. The symbol a and the symbol b are interleaved, and there are 34 interleaved ab in total on each of the 16 PCS lanes. Each a indicates a symbol at one location of the codeword A. For example, a $1^{st}$ a indicates a $543^{rd}$ symbol of the codeword A. Each b indicates a symbol at one location of the codeword B. For example, a $1^{st}$ b indicates a $544^{th}$ symbol of the codeword B.

A possible PCS in IEEE 800G is used as an example. Each PCS includes two RS codewords, the codeword is indicated as KP4 (544, 514), and KP4 (544, 514) indicates that one codeword includes 544 symbols. The PCS in the IEEE 800G mode has 16 PCS lanes in total, and a rate of each lane is 50 Gbps. Every two RS codewords form one group.

Codewords in a first group are indicated as an RS codeword A and an RS codeword B, codewords in a second group are indicated as an RS codeword C and an RS codeword D, and codewords in a third group are indicated as an RS codeword E and an RS codeword F. A symbol of the RS codeword A is indicated as a symbol a, a symbol of the RS codeword B is indicated as a symbol b, a symbol of the RS codeword C is indicated as a symbol c, a symbol of the RS codeword D is indicated as a symbol d, a symbol of the RS codeword E is indicated as a symbol e, and a symbol of the RS codeword F is indicated as a symbol f. One group of RS codewords is allocated to the 16 PCS lanes. One group of RS codewords is used as an example. $2 \times 544/16 = 68$ symbols may be allocated to each PCS lane, and two symbols are interleaved on each lane. Specifically, the codewords in the first group (the RS codeword A and the RS codeword B) are used as an example. The symbol a and the symbol b are interleaved, and there are 34 interleaved ab in total on each of the 16 PCS lanes. Each a indicates a symbol at one location of the codeword a. For example, a 1st a indicates a 543rd symbol of the codeword A. Each b indicates a symbol at one location of the codeword B. For example, a 1st b indicates a 544th symbol of the codeword B.

A possible PCS in IEEE 800G is used as an example. Each PCS includes two RS codewords, the codeword is indicated as KP4 (544, 514), and KP4 (544, 514) indicates that one codeword includes 544 symbols. The PCS in the IEEE 800G mode has 8 PCS lanes in total, and a rate of each lane is 100 Gbps. Every two RS codewords form one group. Codewords in a first group are indicated as an RS codeword A and an RS codeword B, codewords in a second group are indicated as an RS codeword C and an RS codeword D, and codewords in a third group are indicated as an RS codeword E and an RS codeword F. A symbol of the RS codeword A is indicated as a symbol a, a symbol of the RS codeword B is indicated as a symbol b, a symbol of the RS codeword C is indicated as a symbol c, a symbol of the RS codeword D is indicated as a symbol d, a symbol of the RS codeword E is indicated as a symbol e, and a symbol of the RS codeword F is indicated as a symbol f. One group of RS codewords is allocated to the 8 PCS lanes. One group of RS codewords is used as an example. $2 \times 544/8 = 136$ symbols may be allocated to each PCS lane, and two symbols are interleaved on each lane. Specifically, the codewords in the first group (the RS codeword A and the RS codeword B) are used as an example. The symbol a and the symbol b are interleaved, and there are 68 interleaved ab in total on each of the 8 PCS lanes. Each a indicates a symbol at one location of the codeword a. For example, a 1st a indicates a 543rd symbol of the codeword A. Each b indicates a symbol at one location of the codeword B. For example, a 1st b indicates a 544th symbol of the codeword B.

It should be noted that an outer-code codeword on a host-side PCS is RS (544, 514), and a quantity of included codewords may alternatively be 3, 4, or the like. Alternatively, an outer-code codeword on a host-side PCS is RS (576, 514), and a quantity of included codewords is 1, 2, 3, 4, or the like.

2. Field

The field refers to a quantity of symbols input into each level of convolutional interleaver one time. An 800G-ETC mode is used as an example. A total quantity of symbols of two codewords allocated to one PCS lane may be referred to as a symbol set, and one symbol set includes 68 symbols. For example, a first data stream includes three symbol sets, and each field includes four symbols. In this case, each symbol set includes 17 fields. A symbol set 1 is abababab...ab, where ab is repeated 34 times. A symbol set 2 is cdcdcdcd...cd, where cd is repeated 34 times. A symbol set 3 is efefefef...ef, where ef is repeated 34 times. A 1st field to a 17th field are all abab, an 18th field to a 34th field are cdcd, and the rest can be deduced by analogy.

The foregoing describes some terms used in this application. The following describes possible architectures of this application.

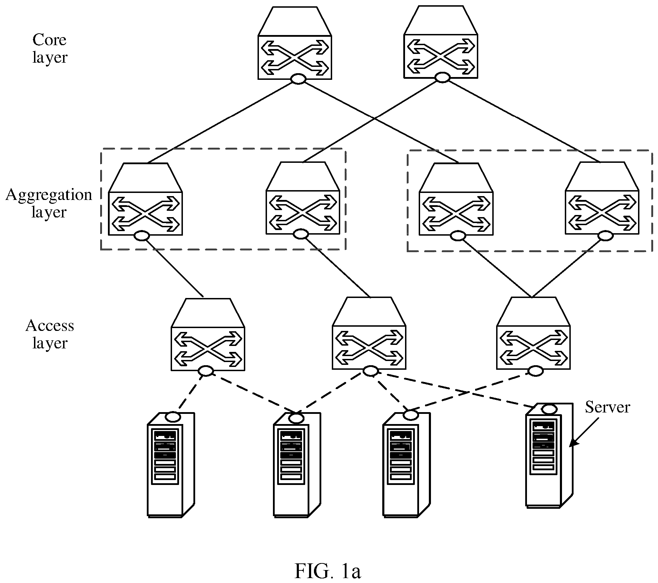

FIG. 1a is a diagram of an architecture of a data center to which this application may be applied. The data center network includes three layers: a core (Core) layer, an aggregation (Aggregation) layer, and an access (Access) layer. The access layer may also be referred to as an edge layer. Each layer may include one or more devices (or referred to as hosts). In FIG. 1a, an example in which the core layer includes two devices, the aggregation layer includes four devices, and the access layer includes three devices is used. A device included in the core layer may be referred to as a core node, a device included in the aggregation layer may be referred to as an aggregation node, and a device included in the access layer may be referred to as an access node or a top of rack (top of rack, TOR) node. The device may be, for example, a switch or a host.

In the architecture shown in FIG. 1a, a downlink port of the access node may be connected to a server (Server), and an uplink port of the access node may be connected to the aggregation node. A downlink port of the aggregation node may be connected to the access node, and an uplink port of the aggregation node may be connected to the core node. The core node may be referred to as an upstream node of the aggregation node, and the aggregation node may be referred to as an upstream node of the access node.

It should be noted that the architecture of the data center shown in FIG. 1a is merely an example, and the data center may alternatively be divided into two layers, or may be divided into at least three layers. In addition, quantities of devices included in the core layer, the aggregation layer, and the access layer may be the same or may be different. This is not limited in this application.

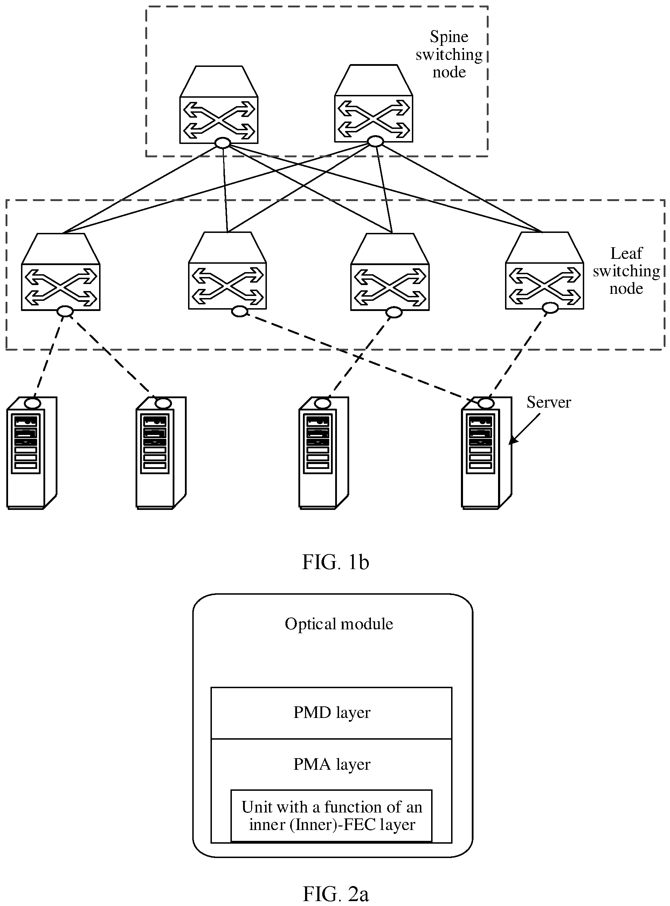

FIG. 1b is a diagram of an architecture of another data center to which this application may be applied. The data center network includes two levels of devices: a spine (spine) device and a leaf (leaf) device. One spine device is configured to be connected to each leaf device, and the leaf device is configured to be connected to a server. In FIG. 1b, an example in which two spine devices and four leaf devices are included is used. It may be understood that the architecture of the data center shown in FIG. 1b is merely an example. Quantities of spine devices and leaf devices included in the data center may be the same or may be different. This is not limited in this application.

The data center may be used in application scenarios such as short-distance interconnection, cloud storage, cloud computing, a 5th generation (5th Generation, 5G) base station backbone network, augmented reality/virtual reality (augmented reality/virtual reality, AR/VR), artificial intelligence (artificial intelligence, AI), optical transmission, optical access, or base station fronthaul. This is not limited in this application.

In a possible implementation, an optical module or an electrical module is further disposed on the device in FIG. 1a or FIG. 1b, to implement communication between devices. The optical module or the electrical module may be a pluggable optical module such as B800 gigabit (G)-SR4, B400G-DR4, B400G-DR4-2, B400G-FR4, B400G-LR4, B400G-FR1, B400G-LR2, or B400G-LR1 for a next-generation Ethernet. 800GBASE-SR4 indicates that transmission of a data stream PCS or PMA of 800 gigabits per second is performed over a PMD with four pairs of multi-mode optical fibers. 800GBASE-SR8 indicates that transmission of a data stream PCS/PMA of 800 gigabits per second is performed over a PMD with eight pairs of multi-mode optical fibers. 800GBASE-SR16 indicates that transmission of a data stream PCS/PMA of 800 gigabits per second is performed over a PMD with 16 pairs of multi-mode optical fibers. 800GBASE-DR4 indicates that transmission of a data stream PCS/PMA of 800 gigabits per second is performed over a PMD with four pairs of single-mode optical fibers, and a coverage range reaches 500 meters (m). 800GBASE-DR8 indicates that transmission of a data stream PCS/PMA of 800 gigabits per second is performed over a PMD with eight pairs of single-mode optical fibers, and a coverage range reaches 500 m. 800GBASE-DR4-2 indicates that transmission of a data stream PCS/PMA of 800 gigabits per second is performed over a PMD with four pairs of single-mode optical fibers, and a coverage range reaches 2 km. 800GBASE-DR8-2 indicates that transmission of a data stream PCS/PMA of 800 gigabits per second is performed over a PMD with eight pairs of single-mode optical fibers, and a coverage range reaches 2 km. 800GBASE-FR4 indicates that a data stream PCS/PMA of 800 gigabits per second uses 4-level amplitude modulation, transmission of the data stream is performed over a PMD with four WDM (wavelength division multiplexing) lanes on one pair of single-mode optical fibers, and a coverage range reaches 2 km. 800GBASE-LR4 indicates that a data stream PCS/PMA of 800 gigabits per second uses 4-level amplitude modulation, transmission of the data stream is performed over a PMD with four wavelength division multiplexing (wavelength division multiplexing, WDM) lanes on one pair of single-mode optical fibers, and a coverage range reaches 10 km.

FIG. 2a is a diagram of a structure of an optical module according to this application. The optical module may include a physical media dependent (physical media dependent, PMD) layer and a physical medium attachment (physical medium attachment, PMA) layer. Further, the PMA layer includes a unit that can implement a function of an inner (Inner)-FEC layer. It may also be understood as that the function of the inner-FEC layer is integrated into the PMA layer.

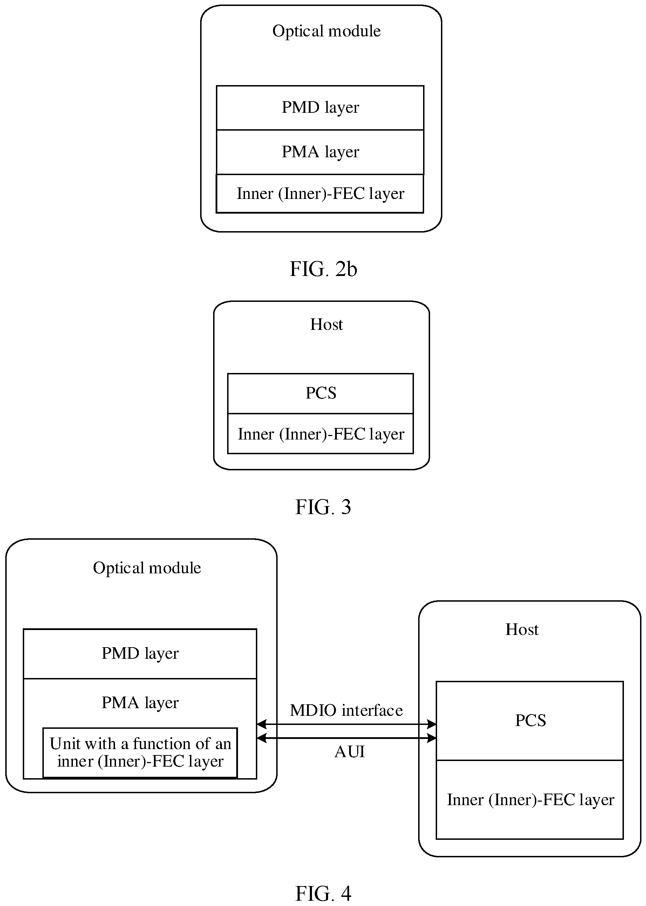

FIG. 2b is a diagram of a structure of another optical module according to this application. The optical module may include a PMD layer, a PMA layer, and an inner-FEC layer. It may also be understood as that the inner-FEC layer and the PMA layer are two independent layers.

FIG. 3 is a diagram of a structure of a device according to this application. The device may include a physical coding sublayer (physical coding sublayer, PCS) and an inner-FEC layer. Alternatively, a function of an inner-FEC layer is integrated into a PCS.

FIG. 4 is a diagram of a communication manner between an optical module and a device according to this application. The optical module in this example uses the structure shown in FIG. 2b as an example. An attachment unit interface (attachment unit interface, AUI) is included between the optical module and the device. Specifically, the PMA layer or the inner-FEC layer of the optical module may communicate with a PCS of the device through the AUI. For example, a data stream may be exchanged between the PMA layer or the inner-FEC layer of the optical module and the PCS of the device through the AUI. Further, a management data input/output (management data input/output, MDIO) interface is further included between the optical module and the device. Specifically, the PMA layer or the FEC layer of the optical module may communicate with the PCS of the device through the MDIO interface. For example, transmission of an indication signal may be performed between the PMA layer or the FEC layer of the optical module and the PCS of the device through the MDIO interface.

Based on the foregoing content, the following describes in detail a data transmission apparatus according to this application with reference to the accompanying drawings.

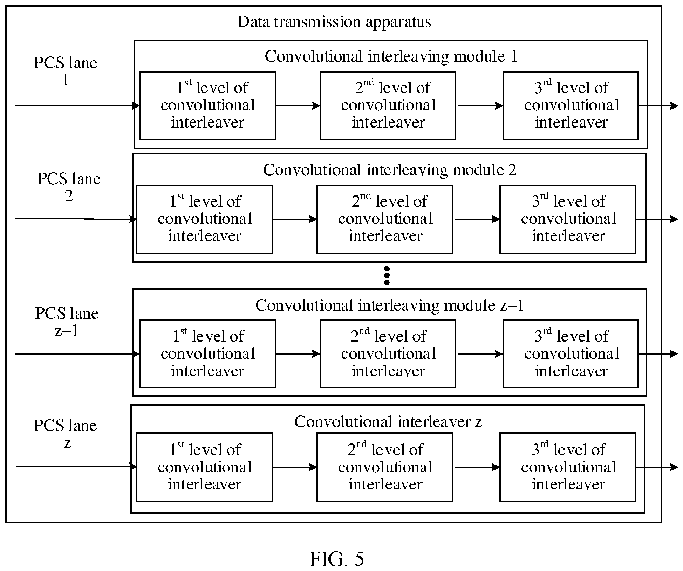

FIG. 5 is a diagram of a structure of a data transmission apparatus according to this application. The data transmission apparatus may include $z$ physical coding sublayer PCS lanes and $z$ convolutional interleaving modules, one convolutional interleaving module corresponds to one PCS lane, the convolutional interleaving module includes $x$ levels of cascaded convolutional interleavers, $x$ is an integer greater than 1, and $z$ is a positive integer, where for example, $z$ is equal to 8, 16, or 32. The PCS lane is configured to receive a first data stream from a PCS, where one first data stream corresponds to one PCS lane. The convolutional interleaving module is configured to perform interleaving processing on a first data stream from a corresponding PCS lane, to obtain a second data stream, where an interleaving depth of the second data stream is related to a quantity of input bits of an inner-code encoder.

With reference to FIG. 2a, FIG. 2b, and FIG. 3, the z convolutional interleaving modules may be integrated into the PMA layer or the inner-FEC layer of the optical module. It may also be understood as that the optical module may include the foregoing data transmission apparatus. Alternatively, the z convolutional interleaving modules may be integrated into the PCS of the device. In other words, the device may include the foregoing data transmission apparatus. This is not limited in this application.

Based on the foregoing data transmission apparatus, a plurality of convolutional interleavers are cascaded, so that a quantity of levels of cascaded interleavers can be flexibly selected, thereby meeting transmission performance of a data stream and helping reduce a transmission delay of the data stream.

In a possible implementation, an inner FEC encoder (n, k) uses encoding in which an input is k bits and an output is n bits, where n and k are positive integers, and k is an integer multiple of a length of a symbol. Encoding in which k=120 and n=128 is extended Hamming encoding, and is also referred to as extended Hamming (128, 120) encoding; encoding in which k=170 and n=180 is extended Hamming encoding, and is also referred to as extended Hamming (180, 170) encoding; encoding in which k=136 and n=144 is Hamming encoding, and is also referred to as Hamming (144,136) encoding; encoding in which k=68 and n=76 is extended Hamming encoding, and is also referred to as extended Hamming (76, 68) encoding; encoding in which k=170 and n=180 is doubly extended Hamming encoding, and is also referred to as doubly extended Hamming (180, 170) encoding; encoding in which k=160 and n=180 is doubly extended Hamming encoding, and is also referred to as doubly extended BCH (180, 160) encoding; or encoding in which k=110 and n=126 is doubly extended Hamming encoding, and is also referred to as doubly extended BCH (126, 110) encoding. It may be understood that k is also referred to as a payload (payload) bit or an information bit.

For example, the inner-code encoder uses the extended Hamming (128, 120) encoding. A length of one symbol is 10 bits, and the quantity of input bits of the inner-code encoder is 120. This indicates that a maximum interleaving depth needed by the inner-code encoder is 120/10=12. Further, it indicates that a maximum interleaving depth of the second data stream output from the data transmission apparatus is 12. It should be noted that, for a maximum interleaving depth needed by an inner-code encoder using another coding scheme, refer to the descriptions of extended Hamming (128, 120). Details are not described herein again.

In a possible implementation, based on a received indication signal, the z convolutional interleaving modules may bypass one or more specific levels of convolutional interleavers and directly enter the inner-code encoder, so that a delay of a convolutional interleaver can be flexibly adjusted, and the inner-code encoder can also be flexibly selected. The indication signal may include but is not limited to a by-pass or bypass (bypass) signal. If the bypass signal is valid, it indicates that a convolutional interleaver needs to be bypassed. If the bypass signal is invalid, it indicates that a convolutional interleaver needs to be passed through (or does not need to be bypassed or is enabled).

The following shows two possible example manners of the indication signal.

Manner 1: The indication signal is a one-dimensional signal.

In a possible implementation, the indication signal indicates to bypass (or by-pass or disable) convolutional interleavers that are of a same level and that are in the z convolutional interleaving modules. It may also be understood as that the convolutional interleavers that are of the same level and that are in the z convolutional interleaving modules share one indication signal. In other words, one indication signal may control the convolutional interleavers that are of the same level and that are in the z convolutional interleaving modules. That a convolutional interleaver is bypassed means that a data stream does not pass through the convolutional interleaver.

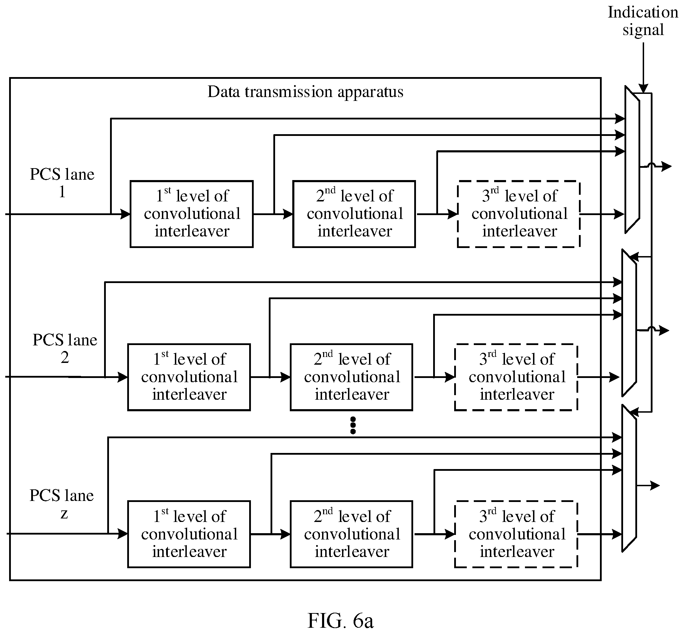

FIG. 6a is a diagram of a structure of z convolutional interleaving modules according to this application. In this example, x=3 is used as an example. For example, one convolutional interleaving module includes a 1st level of convolutional interleaver, a 2nd level of convolutional interleaver, and a 3rd level of convolutional interleaver. One indication signal may indicate to bypass all convolutional interleavers that are of a 3rd level and that are in the z convolutional interleaving modules. In other words, a bypass signal input into the convolutional interleavers that are of the 3rd level and that are in the z convolutional interleaving modules is valid, and a bypass signal input into convolutional interleavers that are of the 2nd level and that are in the z convolutional interleaving modules and convolutional interleavers that are of the 1st level and that are in the z convolutional interleaving modules is invalid. Specifically, the indication signal indicates to bypass the z convolutional interleavers of the 3rd level on a PCS lane 1 to a PCS lane z. In other words, a field 1 from the PCS lane 1 is interleaved by a 1st level of convolutional interleaver and a 2nd level of convolutional interleaver, bypasses (or does not pass through) a 3rd level of convolutional interleaver, and directly enters the inner-code encoder. A field 2 from a PCS lane 2 is interleaved by a 1st level of convolutional interleaver and a 2nd level of convolutional interleaver, does not pass through a 3rd level of convolutional interleaver, and directly enters the inner-code encoder. By analogy, a field z from the PCS lane z is interleaved by a 1st level of convolutional interleaver and a 2nd level of convolutional interleaver, does not pass through a 3rd level of convolutional interleaver, and directly enters the inner-code encoder. It may be understood that the field 1, the field 2, ..., and the field z all belong to the first data stream.

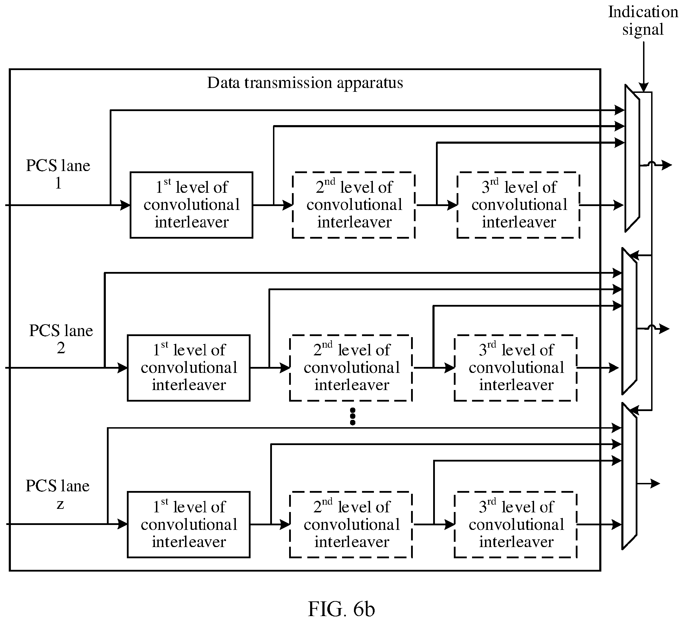

Alternatively, the indication signal may indicate to bypass two or more levels of convolutional interleavers. Refer to FIG. 6b. The indication signal may alternatively indicate to bypass convolutional interleavers that are of a 3rd level and that are in z convolutional interleaving modules and convolutional interleavers that are of a 2nd level and that are in the z convolutional interleaving modules. Specifically, the indication signal indicates to bypass z convolutional interleavers of a 2nd level and z convolutional interleavers of a 3rd level on a PCS lane 1 to a PCS lane z. A field 1 from the PCS lane 1 is interleaved by a 1st level of convolutional interleaver, bypasses (or does not pass through) a 2nd level of convolutional interleaver and a 3rd level of convolutional interleaver, and directly enters the inner-code encoder. A field 2 from a PCS lane 2 is interleaved by a 1st level of convolutional interleaver, does not pass through a 2nd level of convolutional interleaver and a 3rd level of convolutional interleaver, and directly enters the inner-code encoder. By analogy, a field z from the PCS lane z is interleaved by 1st level of convolutional interleaver, does not pass through a 2nd level of convolutional interleaver and a 3rd level of convolutional interleaver, and directly enters the inner-code encoder.

In a possible implementation, in the z convolutional interleaving modules, convolutional interleavers of a same level are connected to one first register included in the optical module. With reference to FIG. 6a or FIG. 6b, in the z convolutional interleaving modules, the z convolutional interleavers of the 1st level are all connected to a first register 1, the z convolutional interleavers of the 2nd level are all connected to a first register 2, and the z convolutional interleavers of the 3rd level are all connected to a first register 3. For example, the indication signal may be indicated by three bits. For example, 001 indicates that a 3rd level of convolutional interleaver is bypassed, 011 indicates that a 2nd level of convolutional interleaver and a 3rd level of convolutional interleaver are bypassed, 111 indicates that a 1st level of convolutional interleaver, a 2nd level of convolutional interleaver, and a 3rd level of convolutional interleaver are bypassed, and 000 indicates that a 1st level of convolutional interleaver, a 2nd level of convolutional interleaver, and a 3rd level of convolutional interleaver are passed through. It should be noted that a specific form of the indication signal may be agreed on in advance, or may be specified in a protocol. This is not limited in this application.

Based on the indication signal in Manner 1, bypassing of one or more specific levels of convolutional interleavers in the z convolutional interleaving modules may be flexibly controlled, so that a bit width of the inner-code encoder does not need to be limited, and the inner-code encoder can further be flexibly selected.

Manner 2: The indication signal is a two-dimensional signal.

In a possible implementation, the indication signal indicates to bypass a jth level of convolutional interleaver in an ith convolutional interleaving module in the z convolutional interleaving modules, where i is an integer less than z, and j is an integer less than x. It may also be understood as that each convolutional interleaving module is controlled by an independent indication signal. In other words, one indication signal may control one or more specific convolutional interleavers. For example, (convolutional interleaving module i, level j of a convolutional interleaver) or (PCS lane i, level j of a convolutional interleaver) may be indicated, where (convolutional interleaving module i, level j of the convolutional interleaver) indicates the jth level of convolutional interleaver in the ith convolutional interleaving module, and (PCS lane i, level j of the convolutional interleaver) indicates a jth level of convolutional interleaver corresponding to an ith PCS lane.

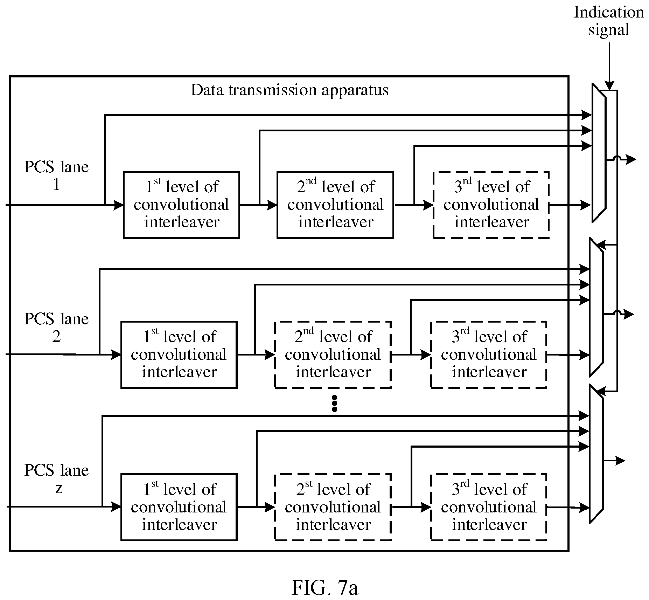

FIG. 7a is a diagram of a structure of other z convolutional interleaving modules according to this application. In this example, x=3 is used as an example. An indication signal (PCS lane 1 to PCS lane z, convolutional interleavers of a 3rd level) indicates to bypass the convolutional interleavers of the 3rd level corresponding to the PCS lane 1 to the PCS lane z, and an indication signal (PCS lane 2 to PCS lane z, convolutional interleavers of a 2nd level) indicates to bypass the convolutional interleavers that are of the 2nd level and that correspond to the PCS lane 2 to the PCS lane z.

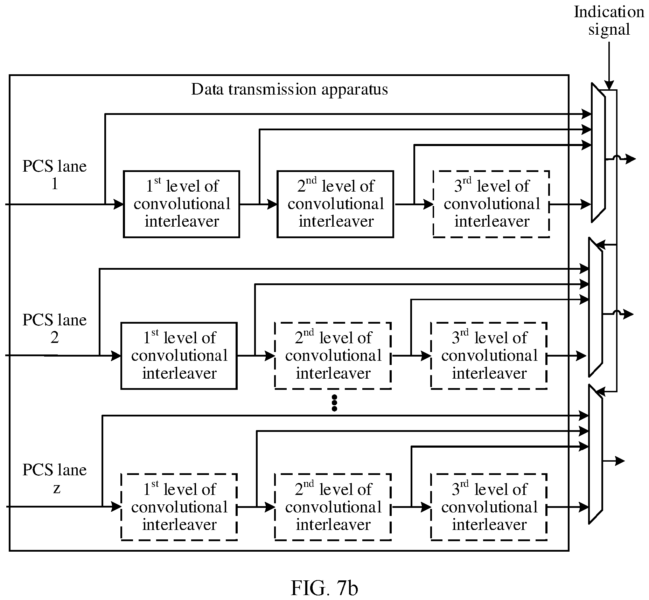

FIG. 7b is a diagram of a structure of other z convolutional interleaving modules according to this application. In this example, x=3 is used as an example. An indication signal (PCS lane 1 to PCS lane z, convolutional interleavers of a 3rd level) indicates to bypass the convolutional interleavers that are of the 3rd level and that correspond to the PCS lane 1 to the PCS lane z, an indication signal (PCS lane 2 to PCS lane z, convolutional interleavers of a 2nd level) indicates to bypass the convolutional interleavers that are of the 2nd level and that correspond to the PCS lane 2 to the PCS lane z, and an indication signal (PCS lane z, 1st level of convolutional interleaver) indicates to bypass the 1st level of convolutional interleaver corresponding to the PCS lane z.

In a possible implementation, convolutional interleavers of one level are connected to one first register. With reference to FIG. 7a and FIG. 7b, convolutional interleavers of each level in the z convolutional interleaving modules are connected to one first register. An interleaving module corresponding to the PCS lane 1 is used as an example. A 1st level of convolutional interleaver is connected to a first register 1, a 2nd level of convolutional interleaver is connected to a first register 2, and a 3rd level of convolutional interleaver is connected to a first register 3. For example, the indication signal may be indicated by one bit. For example, 1 indicates to bypass a convolutional interleaver, and 0 indicates to bypass a convolutional interleaver.

In another possible implementation, some of the convolutional interleavers of the same level share one first register. With reference to FIG. 7b, in an example, the convolutional interleavers that are of the 2nd level and that correspond to the PCS lane 2 to the PCS lane z are all connected to one first register. It may also be understood as that (z-1) convolutional interleavers of the 2nd level are all connected to one first register, and a 2nd level of convolutional interleaver corresponding to the PCS lane 1 is connected to one first register. In another example, convolutional interleavers that are of the 2nd level and that correspond to the PCS lane 1 and the PCS lane 2 are both connected to one first register, and convolutional interleavers that are of the 2nd level and that correspond to a PCS lane 3 to the PCS lane z are connected to one first register.

The indication signal in Manner 2 may be used to independently control a quantity of levels of cascaded convolutional interleavers in each convolutional interleaving module, so that different PCS lanes have different error correction capabilities. This helps further increase applicable scenarios. For example, a breakout (Breakout) transmission mode may be supported.

It should be noted that, for each convolutional interleaving module, the indication signal needs to indicate to bypass a convolutional interleaver of a last level as a start, and cross-level bypassing is not allowed. With reference to FIG. 7b, for each convolutional interleaving module, the indication signal needs to indicate to bypass a 3rd level of convolutional interleaver as a start.

Based on the foregoing content, the following shows examples of possible implementations of transmission of the indication signal.

Implementation 1: The transmission of the indication signal is performed through an MDIO interface between the device and the optical module.

In a possible implementation, the device sends first information to the optical module through the MDIO interface. The first information includes a value of an MDIO control bit, and the MDIO control bit is mapped to a control bit of x levels of convolutional interleavers. Correspondingly, the optical module receives the first information from a host through the MDIO interface, and the PMA layer or the FEC layer may control to bypass, based on the first information, one or more specific levels in the x levels of convolutional interleavers.

Table 1 shows a mapping relationship between the MDIO control bit and control bits of three levels of convolutional interleavers according to this application. In Table 1, an example in which a convolutional interleaving module includes three levels of convolutional interleavers (a 1st level of convolutional interleaver, a 2nd level of convolutional interleaver, and a 3rd level of convolutional interleaver) is used. Specifically, controlling of the 3rd level of convolutional interleaver is used as an example. Inner-CI-3 bypass indication enable (column 1 in Table 1) on a host side sends, to Inner-FEC control register (column 2) on an optical module side through the MDIO interface, a value (for example, 1 or 0) of a control bit (column 3) of a first register included in the host. Inner-FEC control register on the optical module side refreshes the value of the control bit of the first register corresponding to the corresponding 3rd level of convolutional interleaver to the other value (for example, 0 or 1), and controls to bypass or pass through the 3rd level of convolutional interleaver through FEC_bypass_CI3_enable (column 4). 1.200.6 is used as an example. "1" indicates an address of the device, "200" indicates an address of the register, and "6" indicates the control bit of the register. It may be understood that a value of a control bit of a first register connected to a convolutional interleaver is related to a bypass indication signal. For example, if the value of the control bit of the first register connected to the convolutional interleaver is 1, it indicates that the bypass indication signal is valid; or if the value of the control bit of the first register connected to the convolutional interleaver is 0, it indicates that the bypass indication signal is invalid.

Table 1 Mapping relationship between an MDIO control bit and control bits of three levels of cascaded convolutional interleavers

| MDIO control variable | PMA/PMD register name | Register/bit number | FEC variable |
|---|---|---|---|
| FEC bypass correction enable | Inner-FEC control register | 1.200.6 | FEC_bypass_correction_enable |
| FEC bypass indication enable | Inner-FEC control register | 1.200.7 | FEC_bypass_indication_enable |
| Inner-CI-3 bypass indication enable | Inner-FEC control register | 1.200.8 | FEC_bypass_CI3_enable |
| Inner-CI-2 bypass indication enable | Inner-FEC control register | 1.200.9 | FEC_bypass_CI2_enable |
| Inner-CI-1 bypass indication enable | Inner-FEC control register | 1.200.10 | FEC_bypass_CI1_enable |

In Table 1, when FEC_bypass_correction_enable is set to 1, it indicates that an inner-code decoder performs error detection instead of error correction. When FEC_bypass_correction_enable is set to 0, it indicates that an inner-code decoder performs error detection and error correction. When FEC bypass indication enable is set to 1, it indicates that an error indication function is bypassed. When FEC bypass indication enable is set to 0, it indicates that the decoder indicates an error to the PCS.

When Inner-CI-3 bypass indication enable is set to 1, it indicates that a function of the 3rd level of convolutional

interleaver (CI 3) is bypassed, or it indicates that the $3^{rd}$ level of convolutional interleaver is bypassed. When Inner-CI-3 bypass indication enable is set to 0, it indicates that a function of the $3^{rd}$ level of convolutional interleaver is not bypassed, or it indicates that the $3^{rd}$ level of convolutional interleaver is passed through (or not bypassed). When Inner-CI-2 bypass indication enable is set to 1, it indicates that a function of the $2^{nd}$ level of convolutional interleaver (CI 2) is bypassed, or it indicates that the $2^{nd}$ level of convolutional interleaver is bypassed. When Inner-CI-2 bypass indication enable is set to 0, it indicates that a function of the $2^{nd}$ level of convolutional interleaver is not bypassed. When Inner-CI-1 bypass indication enable is set to 1, it indicates that a function of the $1^{st}$ level of convolutional interleaver (CI 1) is bypassed, or it indicates that the $1^{st}$ level of convolutional interleaver is bypassed. When Inner-CI-1 bypass indication enable is set to 0, it indicates that a function of the $1^{st}$ level of convolutional interleaver is not bypassed. It should be noted that a default value of each variable in Table 1 is 0.

In Table 2, an example in which a convolutional interleaving module includes three levels of convolutional interleavers (for example, a $1^{st}$ level of convolutional interleaver, a $2^{nd}$ level of convolutional interleaver, and a $3^{rd}$ level of convolutional interleaver) is used. The inner-FEC layer may select to bypass a function of the $3^{rd}$ level of convolutional interleaver (CI 3), and/or the $2^{nd}$ level of convolutional interleaver (CI 2), and/or the $1^{st}$ level of convolutional interleaver (CI 1). In this way, a delay of the inner-FEC layer can be reduced. Further, the PMA layer of the optical module may report Table 2 to the host, so that the host determines the indication signal.

Table 2 Mapping relationship between an MDIO status and status bits of three levels of cascaded convolutional interleavers

| MDIO control variable | PMA/PMD register name | Register/bit number | FEC variable |
|---|---|---|---|
| Inner-CI-3 bypass indication ability | Inner-FEC status register | 1.201.2 | FEC_bypass_CI3__ability |
| Inner-CI-2 bypass indication ability | Inner-FEC status register | 1.201.3 | FEC_bypass_CI2_ability |
| Inner-CI-1 bypass indication ability | Inner-FEC status register | 1.201.5 | FEC_bypass_CI1_ability |

When Inner-CI-3 bypass indication ability is set to 1, it indicates that the inner-FEC layer has an ability of bypassing the $3^{rd}$ level of convolutional interleaver (CI 3). When Inner-CI-3 bypass indication ability is set to 0, it indicates that the inner-FEC layer does not support a function of bypassing the $3^{rd}$ level of convolutional interleaver (CI 3). When Inner-CI-2 bypass indication ability is set to 1, it indicates that the inner-FEC layer has an ability of bypassing the $2^{nd}$ level of convolutional interleaver (CI 2). When Inner-CI-1 bypass indication ability is set to 0, it indicates that the inner-FEC layer does not support a function of bypassing the $1^{st}$ level of convolutional interleaver (CI 1). It should be noted that a default value of each variable in Table 2 is 0.

Implementation 2: The transmission of the indication signal is performed through a common management interface specification (common management interface specification, CMIS) interface between the device and the optical module.

In a possible implementation, the device may determine to bypass one or more specific convolutional interleavers and pass through (or not bypass) one or more specific convolutional interleavers, and the device may update, to the optical module through the CMIS interface, a value of a control bit of a first register corresponding to the convolutional interleaver. With reference to FIG. 6a, the device may determine to bypass the convolutional interleavers that are of the $3^{rd}$ level and that are in the z convolutional interleaving modules, pass through the convolutional interleavers of the $1^{st}$ level and the convolutional interleavers of the $2^{nd}$ level, and refresh, through the CMIS interface, a value of a control bit of a first register corresponding to the convolutional interleavers of the $3^{rd}$ level to 1, and values of control bits of first registers corresponding to the convolutional interleavers of the $1^{st}$ level and the convolutional interleavers of the $2^{nd}$ level to 0.

For example, the CMIS interface may include but is not limited to an inter-integrated circuit I2C bus common software interface.

Implementation 3: The transmission of the indication signal is performed through an AUI between the device and the optical module.

In a possible implementation, the indication signal is a first preset sequence. Specifically, the PCS inserts the first preset sequence into an AM sequence. Further, the PCS may insert the first preset sequence into a pad (pad) bit of the AM sequence. The PCS sends, to the PMA layer or the FEC layer, a first data stream obtained through the insertion, where the first data stream includes an AM sequence, and the AM sequence includes the first preset sequence. Correspondingly, the PMA layer or the FEC layer may extract the corresponding first preset sequence in a process of performing AM lock (Lock) on the first data stream, to determine to bypass one or more specific convolutional interleavers. Alternatively, after performing AM lock (Lock) on the first data stream, the PMA layer or the FEC layer extracts the corresponding first preset sequence, to determine to bypass one or more specific convolutional interleavers.

In another possible implementation, the indication signal is a second preset sequence. Specifically, the PCS separately sends the second preset sequence to the PMA layer or the FEC layer. Correspondingly, the PMA layer or the FEC layer may determine to bypass one or more specific convolutional interleavers based on the second preset sequence.

It should be noted that the first preset sequence and the second preset sequence may be agreed in advance by the PCS and the PMA layer or the FEC layer, or may be specified in a protocol. This is not limited in this application.

It may be understood that the indication signal may be alternatively implemented in another possible transmission manner. The foregoing three implementations are merely examples. This is not limited in this application.

In a possible implementation, a data stream on the PCS is transmitted to the PMA layer or the FEC layer through the z PCS lanes (or referred to as logical lanes). The PMA layer or the FEC layer performs restoring (or demultiplexing) to obtain z data streams. An AM lock module included in the data transmission apparatus may first align boundaries of symbols of the z data streams. Specifically, the AM lock module performs a symbol boundary lock operation on the z data streams. The symbol boundary lock operation on the z data streams is also referred to as an alignment operation on boundaries of symbol-level data blocks (for example, 10-bit RS symbols), AM lock (Lock), boundary lock of 10-bit data blocks, alignment of q symbols, boundary alignment of q×10-bit data blocks, boundary lock of q symbols, or boundary lock of q×10-bit data blocks. For a specific process, refer to descriptions in a conventional technology. Details are not described herein.

The symbol in this application may be, for example, an RS symbol, a semi-RS symbol, or a 4-level pulse amplitude modulation (4-level pulse amplitude modulation, PAM4) symbol. This is not limited in this application. The RS symbol is a data block with a length of 10 bits, the semi-RS symbol is a data block with a length of 5 bits, and the PAM4 symbol is a data block with a length of 2 bits.

Further, first data streams from the z PCS lanes are independently interleaved based on the z convolutional interleaving modules. A minimum unit of a first data stream input into x levels of cascaded convolutional interleavers included in a convolutional interleaving module is a symbol. It may also be understood as that a granularity of a first data stream input into a convolutional interleaver is a symbol. Specifically, a length of a field input into the convolutional interleaver one time includes q symbols, where for example, q=1, 2, 4, or 8. The first data stream includes a plurality of fields, one field is input into the convolutional interleaver each time, and a length of the corresponding field is 10 bits, 20 bits, 40 bits, or 80 bits.

In the following, one of the z convolutional interleaving modules is used as an example, and is referred to as a first convolutional interleaving module. The first convolutional interleaving module includes x levels of convolutional interleavers. One level of convolutional interleaver in the x levels of convolutional interleavers is used as an example, and is referred to as a $k^{th}$ level of convolutional interleaver, where k is a positive integer less than or equal to x.

The following describes, in different cases, a relationship between a quantity of symbols input into a sub-lane of the $k^{th}$ level of convolutional interleaver and a quantity of symbols output from the sub-lane of the $k^{th}$ level of convolutional interleaver.

Case 1: The quantity of symbols input into the sub-lane of the $k^{th}$ level of convolutional interleaver is equal to the quantity of symbols output from the sub-lane of the $k^{th}$ level of convolutional interleaver.

In other words, both the quantity of symbols input into the sub-lane of the $k^{th}$ level of convolutional interleaver and the quantity of symbols output from the sub-lane of the $k^{th}$ level of convolutional interleaver are $w_k$. It may also be understood as that, a size of an input slice data block on the sub-lane of the $k^{th}$ level of convolutional interleaver is equal to a size of an output slice data block.

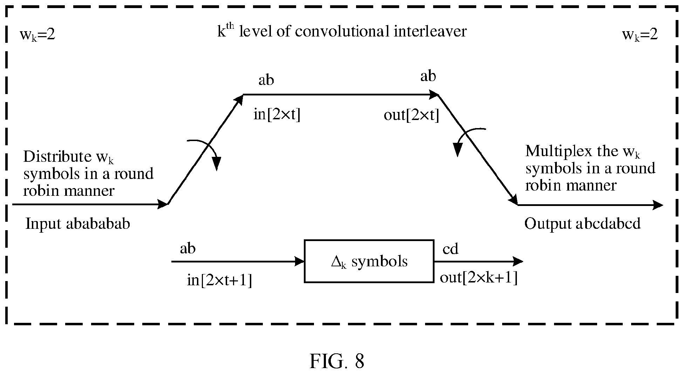

Parameters of the $k^{th}$ level of convolutional interleaver include ($w_k$, $p_k$, $\Delta_k$), where $w_k$ indicates the quantity of symbols input into the sub-lane of the $k^{th}$ level of convolutional interleaver, $p_k$ indicates a quantity of sub-lanes included in the $k^{th}$ level of convolutional interleaver, and $\Delta_k$ indicates a delay of the $k^{th}$ level of convolutional interleaver, and specifically indicates that the $k^{th}$ level of convolutional interleaver is delayed by $\Delta_k$ symbols. Refer to FIG. 8. An example in which the $k^{th}$ level of convolutional interleaver includes two sub-lanes (a sub-lane 1 and a sub-lane 2) is used. A field abababab is input into the $k^{th}$ level of convolutional interleaver, where a is from a codeword A, and b is from a codeword B. The quantity $w_k$ of symbols input into the sub-lane of the $k^{th}$ level of convolutional interleaver is 2, and $w_k$ symbols are distributed to $p_k$ sub-lanes in a round robin manner. Specifically, a distribution moment $T_1$ of the sub-lane 1 is 2×t, and a distribution moment $T_2$ of the sub-lane 2 is 2×t+1, where t is an integer. It may also be understood as that the $w_k$ symbols are distributed to the sub-lane 1 at a moment 0, the $w_k$ symbols are distributed to the sub-lane 2 at a moment 1, the $w_k$ symbols are distributed to the sub-lane 1 at a moment 2, the $w_k$ symbols are distributed to the sub-lane 2 at a moment 3, the $w_k$ symbols are distributed to the sub-lane 1 at a moment 4, the $w_k$ symbols are distributed to the sub-lane 2 at a moment 5, and the rest can be deduced by analogy. A delay of the sub-lane 1 is 0 symbols, and a delay of the sub-lane 2 is $\Delta_k$ symbols.

It should be noted that the sub-lane 1 may alternatively have a delay. For example, the delay of the sub-lane 1 is $\Delta_k$ symbols, and the delay of the sub-lane 2 is $2\Delta_k$ symbols. Alternatively, the two sub-lanes may have another possible delay relationship. This is not limited in this application. In addition, the sub-lanes included in the $k^{th}$ level of convolutional interleaver may alternatively start from a sequence number 0. For example, the $k^{th}$ level of convolutional interleaver includes a sub-lane 0, a sub-lane 1, and the like. For ease of description of the solution, in this application, an example in which the quantity of sub-lanes included in the $k^{th}$ level of convolutional interleaver may alternatively start from a sequence number 1 is used for description.

Based on this, an output interleaving depth of the $k^{th}$ level of convolutional interleaver is $w_k \times p_k$. An input interleaving depth of the $k^{th}$ level of convolutional interleaver is $w_{k-1} \times p_{k-1}$. It may also be understood as that an input interleaving depth of a convolutional interleaver of a current level is determined by an output interleaving depth of a convolutional interleaver of a previous level. For example, an input interleaving depth of a $2^{nd}$ level of convolutional interleaver is equal to $w_1 \times p_1$, an input interleaving depth of a $3^{rd}$ level of convolutional interleaver is equal to $w_2 \times p_2$, ..., and an input interleaving depth of an $x^{th}$ level of convolutional interleaver is equal to $w_{x-1} \times p_{x-1}$. It should be noted that, when k=1, an input interleaving depth of a $1^{st}$ level of convolutional interleaver is related to a coding scheme of the PCS and a symbol distribution manner. Specifically, the coding scheme of the PCS includes encoding by two encoders, for example, an encoder A and an encoder B. The encoders both use RS (5440, 5140, 10) encoding. To be specific, an input of the encoder A is 514 symbols, and an output is 544 symbols. An input of the encoder B is 514 symbols, and an output is 544 symbols. The symbols output from the encoder A and the symbols output from the encoder B are distributed on the z PCS lanes in a round robin manner. It may also be understood as that a $543^{rd}$ symbol of the encoder A is distributed to the PCS lane 1, and a $543^{rd}$ symbol of the encoder B is distributed to the PCS lane 2; a $542^{nd}$ symbol of the encoder A is distributed to the PCS lane 3, and a $542^{nd}$ symbol of the encoder B is distributed to a PCS lane 4; ...; and a $(543-(z/2))^{th}$ symbol of the encoder A is distributed to a PCS lane z-1, and a $(543-(z/2))^{th}$ symbol of the encoder B is distributed to the PCS lane z. Then, a $(543-(z/2)-1)^{th}$ symbol of the encoder B is distributed to the PCS lane 1, and a $(543-(z/2)-1)^{th}$ symbol of the encoder A is distributed to the PCS lane 2; a $(543-(z/2)-2)^{th}$ symbol of the encoder B is distributed to the PCS lane 3 and a $(543-(z/2)-2)^{th}$ symbol of the encoder A is distributed to the PCS lane 4; and a $(543-(z/2)-(z/2))^{th}$ symbol of the encoder B is distributed to the PCS lane z-1, and a $(543-(z/2)-(z/2))^{th}$ symbol of the encoder A is distributed to the PCS lane z. In this case, the input interleaving depth Num_RS of the $1^{st}$ level of convolutional interleaver is 2. Num_RS=2 indicates that the PCS includes two interleaving depths, or indicates that the PCS includes one interleaving depth, and a lane permutation (Lane Permutation) operation is performed on the PMA layer or the FEC layer.

Further, an input interleaving depth of the first convolutional interleaving module is the same as the input interleaving depth of the $1^{st}$ level of convolutional interleaver. An output interleaving depth of the first convolutional interleaving module is $w_x \times p_x$, where $w_x$ is a quantity of symbols input into a sub-lane of the $x^{th}$ level of convolutional interleaver in the first convolutional interleaving module, $p_x$ is a quantity of sub-lanes included in the $x^{th}$ level of convolutional interleaver in the first convolutional interleaving module, and the output interleaving depth of the first convolutional interleaving module is the same as an output interleaving depth of the $x^{th}$ level of convolutional interleaver. It may also be understood as that the input interleaving depth of the $1^{st}$ level of convolutional interleaver is the input interleaving depth of the first convolutional interleaving module, and the output interleaving depth of the $x^{th}$ level of convolutional interleaver is the output interleaving depth of the first convolutional interleaving module.

When k is a positive integer greater than 1 and less than or equal to x, delays of the $k^{th}$ level of convolutional interleaver and the $1^{st}$ level of convolutional interleaver satisfy Formula 1 below:

$$\Delta_k \geq \left\lceil \frac{p_1}{p_k} \times \frac{w_k}{w_1} \right\rceil \times \Delta_1 \quad \text{Formula 1}$$

$w_1$ is a quantity of symbols input into a sub-lane of the $1^{st}$ level of convolutional interleaver, $p_1$ is a quantity of sub-lanes included in the $1^{st}$ level of convolutional interleaver, and $\Delta_1$ is a delay between two adjacent sub-lanes in the $1^{st}$ level of convolutional interleaver.

Further, the delays of the $k^{th}$ level of convolutional interleaver and the $1^{st}$ level of convolutional interleaver satisfy Formula 2 below:

$$\Delta_k = \left\lceil \frac{p_1}{p_k} \right\rceil \times \left\lceil \frac{w_k}{w_1} \right\rceil \times \Delta_1 \quad \text{Formula 2}$$

In a possible implementation, the delay $\Delta_1$ between the two adjacent sub-lanes in the $1^{st}$ level of convolutional interleaver is an integer multiple of the input interleaving depth of the first convolutional interleaving module, and satisfies Formula 3 below:

$$\Delta_1 > \left\lceil \frac{L}{P1} \right\rceil \quad \text{Formula 3}$$

L is a quantity of symbols allocated to a PCS lane corresponding to the first convolutional interleaving module. With reference to the 800G-ETC mode above, the quantity of symbols allocated to the PCS lane corresponding to the first convolutional interleaving module is 68, that is, L=68.

The following further includes two possible cases depending on whether quantities of sub-lanes included in the x levels of convolutional interleavers are the same.

Case 1.1: The quantities of sub-lanes of the x levels of convolutional interleavers included in the first convolutional interleaving module are different.

In a possible implementation, the quantity of sub-lanes of the 1st level of convolutional interleaver in the first convolutional interleaving module is different from quantities of sub-lanes of (x-1) levels of convolutional interleavers other than the 1st level of convolutional interleaver included in the first convolutional interleaving module, and the quantities of sub-lanes of the (x-1) levels of convolutional interleavers other than the 1st level of convolutional interleaver included in the first convolutional interleaving module are the same.

For example, the 1st level of convolutional interleaver includes three sub-lanes (that is, $p_1$=3), and each of the (x-1) levels of convolutional interleavers other than the 1st level of convolutional interleaver includes two sub-lanes (that is, $p_2$ to $p_x$=2). Specifically, parameters of the 1st level of convolutional interleaver include ($w_1$, 3, $\Delta_1$, $2\Delta_1$), parameters of the 2nd level of convolutional interleaver include ($w_2$, 2, $\Delta_2$), parameters of the 3rd level of convolutional interleaver include ($w_3$, 2, $\Delta_3$), and by analogy, parameters of the $x^{th}$ level of convolutional interleaver include ($w_x$, 2, $\Delta_x$).

Delays of two adjacent levels of convolutional interleavers in the (x-1) levels of convolutional interleavers other than the 1st level of convolutional interleaver in the first convolutional interleaving module satisfy Formula 4 below:

$$\Delta_k = 2 \times \Delta_{k-1} = 2^{k-1} \times 3 \times \Delta_1 \quad \text{Formula 4}$$

$\Delta_k$ is a delay of the $k^{th}$ level of interleaver, and $\Delta_{k-1}$ is a delay of a $(k-1)^{th}$ level of interleaver.

With reference to Formula 4 above, the parameters of the 1st level of convolutional interleaver include ($w_1$, 3, $\Delta_1$, $2\Delta_1$), the parameters of the 2nd level of convolutional interleaver include ($w_2$, 2, $\Delta_2$=6$\times\Delta_1$), the parameters of the 3rd level of convolutional interleaver include ($w_3$, 2, $\Delta_3$=12$\times\Delta_1$), and by analogy, the parameters of the $x^{th}$ level of convolutional interleaver include ($w_x$, 2, $\Delta_x$= $2^{x-1} \times 3 \times \Delta_1$).

For example, L=68, the first convolutional interleaving module includes the 1st level of convolutional interleaver and the 2nd level of convolutional interleaver. The delay between the two adjacent sub-lanes in the 1st level of convolutional interleaver is 24 symbols, and/or a delay of the 2nd level of convolutional interleaver is 144 symbols. For another example, the first convolutional interleaving module includes the 1st level of convolutional interleaver and the 2nd level of convolutional interleaver. The delay between the two adjacent sub-lanes in the 1st level of convolutional interleaver is 24 symbols, and/or a delay of the 2nd level of convolutional interleaver is 120 symbols. For another example, the first convolutional interleaving module includes the 1st level of convolutional interleaver and the 2nd level of convolutional interleaver. The delay between the two adjacent sub-lanes in the 1st level of convolutional interleaver is 26 symbols, and/or a delay of the 2nd level of convolutional interleaver is 130 symbols. For another example, the first convolutional interleaving module includes the 1st level of convolutional interleaver and the 2nd level of convolutional interleaver. The delay between the two adjacent sub-lanes in the 1st level of convolutional interleaver is 26 symbols, and/or a delay of the 2nd level of convolutional interleaver is 156 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 24 symbols, and/or a delay of the 2nd level of convolutional interleaver is 144 symbols, and/or a delay of the 3nd level of convolutional interleaver is 288 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 36 symbols, and/or a delay of the 2nd level of convolutional interleaver is 72 symbols, and/or a delay of the 3rd level of convolutional interleaver is 144 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 24 symbols, and/or a delay of the 2nd level of convolutional interleaver is 120 symbols, and/or a delay of the 3rd level of convolutional interleaver is 216 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 26 symbols, and/or a delay of the 2nd level of convolutional interleaver is 130 symbols, and/or a delay of the 3rd level of convolutional interleaver is 234 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 24 symbols, and/or a delay of the 2nd level of convolutional interleaver is 120 symbols, and/or a delay of the 3rd level of convolutional interleaver is 240 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 26 symbols, and/or a delay of the 2nd level of convolutional interleaver is 130 symbols, and/or a delay of the 3rd level of convolutional interleaver is 260 symbols.

For example, L=136, the first convolutional interleaving module includes the 1st level of convolutional interleaver and the 2nd level of convolutional interleaver. The delay between the two adjacent sub-lanes in the 1st level of convolutional interleaver is 46 symbols, and/or a delay of the 2nd level of convolutional interleaver is 230 symbols. For another example, the first convolutional interleaving module includes the 1st level of convolutional interleaver and the 2nd level of convolutional interleaver. The delay between the two adjacent sub-lanes in the 1st level of convolutional interleaver is 46 symbols, and/or a delay of the 2nd level of convolutional interleaver is 276 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 46 symbols, and/or a delay of the 2nd level of convolutional interleaver is 230 symbols, and/or a delay of the 3rd level of convolutional interleaver is 414 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 46 symbols, and/or a delay of the 2nd level of convolutional interleaver is 276 symbols, and/or a delay of the 3rd level of convolutional interleaver is 552 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 48 symbols, and/or a delay of the 2nd level of convolutional interleaver is 240 symbols, and/or a delay of the 3rd level of convolutional interleaver is 432 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 48 symbols, and/or a delay of the 2nd level of convolutional interleaver is 288 symbols, and/or a delay of the 3rd level of convolutional interleaver is 576 symbols.

An example in which the first convolutional interleaving module includes three levels of convolutional interleavers is used to describe parameters configured for each level of convolutional interleaver.

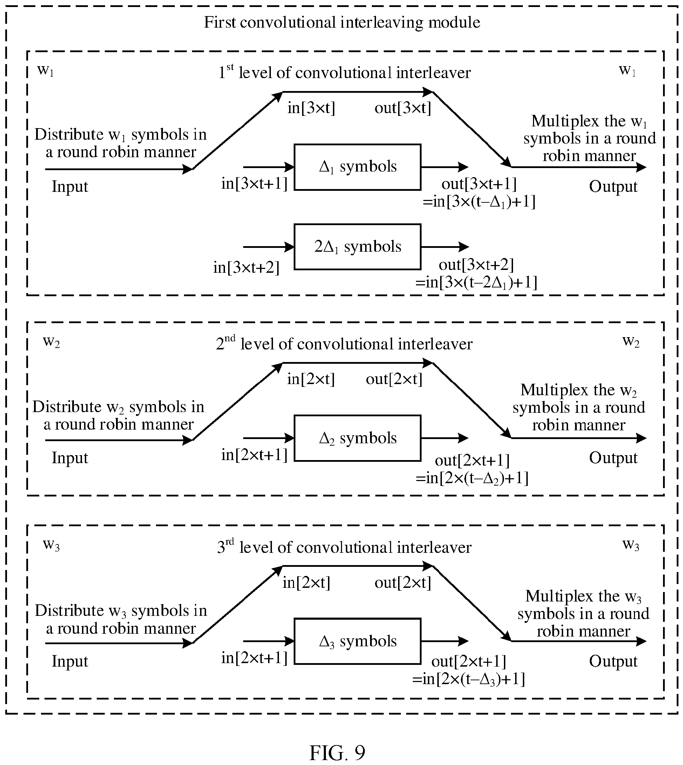

FIG. 9 is a diagram of a structure of a first convolutional interleaving module according to this application. In this example, the first convolutional interleaving module includes a 1st level of convolutional interleaver, a 2nd level of convolutional interleaver, and a 3rd level of convolutional interleaver.

k=1, and parameters of the 1st level of convolutional interleaver include $(w_1, p_1, \Delta_1, 2\Delta_1)$, where $w_1$ indicates a quantity of symbols input into a sub-lane of the 1st level of convolutional interleaver, $p_1$ indicates a quantity of sub-lanes of the 1st level of convolutional interleaver, and $\Delta_1$ indicates a delay between two adjacent sub-lanes in the 1st level of convolutional interleaver. With reference to FIG. 9, $p_1$=3 is used as an example. The 1st level of convolutional interleaver includes three sub-lanes, $w_1$ symbols are distributed to the three sub-lanes in a round robin manner (for details, refer to the foregoing related descriptions), a sub-lane 1 is delayed by 0 symbols, a sub-lane 2 is delayed by $\Delta_1$ symbols, and a sub-lane 3 is delayed by $2\Delta_1$ symbols. Then, the $w_1$ symbols on the three sub-lanes are multiplexed in a round robin manner, and $w_1$ multiplexed symbols are used as an output of the 1st level of convolutional interleaver.

k=2, and parameters of the 2nd level of convolutional interleaver include $(w_2, p_2, \Delta_2)$, where $w_2$ indicates a quantity of symbols input into a sub-lane of the 2nd level of convolutional interleaver, $p_2$ indicates a quantity of sub-lanes of the 2nd level of convolutional interleaver, and $\Delta_2$ indicates a delay of the 2nd level of convolutional interleaver. With reference to FIG. 9, $p_2$=2 is used as an example. The 2st level of convolutional interleaver includes two sub-lanes, $w_2$ symbols are distributed to the two sub-lanes in a round robin manner, a sub-lane 1 is delayed by 0 symbols, and a sub-lane 2 is delayed by $\Delta_2$ symbols. Then, the $w_2$ symbols on the two sub-lanes are multiplexed in a round robin manner, and $w_2$ multiplexed symbols are used as an output of the 2nd level of convolutional interleaver.

k=3, and parameters of the 3rd level of convolutional interleaver include $(w_3, p_3, \Delta_3)$, where $w_3$ indicates a quantity of symbols input into a sub-lane of the 3rd level of convolutional interleaver, $p_3$ indicates a quantity of sub-lanes of the 3rd level of convolutional interleaver, and $\Delta_3$ indicates a delay of the 3rd level of convolutional interleaver. With reference to FIG. 9, $p_3$=2 is used as an example. The 1st level of convolutional interleaver includes two sub-lanes, $w_3$ symbols are distributed to the two sub-lanes in a round robin manner, a sub-lane 1 is delayed by 0 symbols, and a sub-lane 2 is delayed by $\Delta_3$ symbols. Then, the $w_3$ symbols on the two sub-lanes are multiplexed in a round robin manner, and $w_3$ multiplexed symbols are used as an output of the 3rd level of convolutional interleaver.

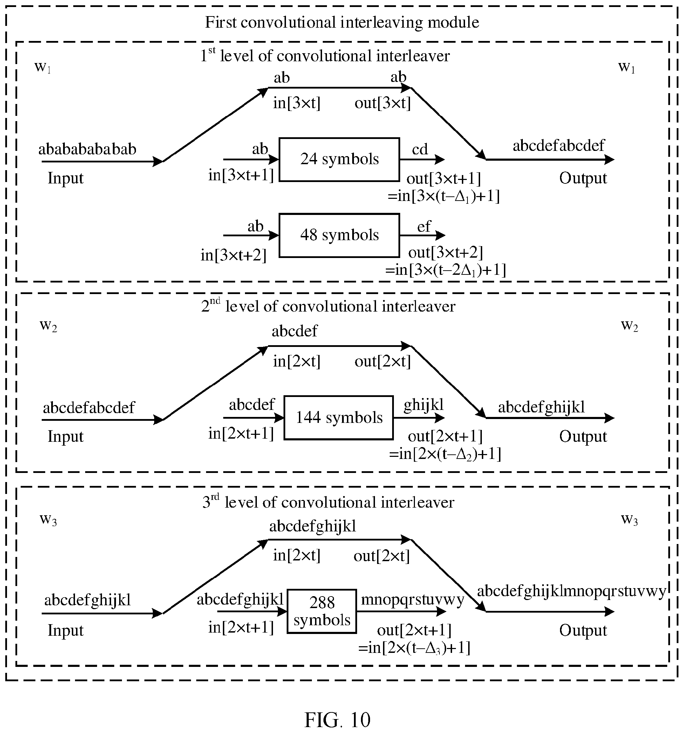

Refer to FIG. 10. $\Delta_1$=24 is used as an example. The parameters of the 1st level of convolutional interleaver are configured as $(w_1, p_1, \Delta_1, 2\Delta_1)=(2, 3, 24, 48)$, and an output interleaving depth of the 1st level of convolutional interleaver is $w_1 \times p_1$=6. The parameters of the 2nd level of convolutional interleaver are configured as $(w_2, p_2, \Delta_2=6\times\Delta_1)=(6, 2, 144)$, an output interleaving depth of the 2nd level of convolutional interleaver is $w_2 \times p_2$=12, and an input interleaving depth of the 2nd level of convolutional interleaver is $w_1 \times p_1$=6. The parameters of the 3rd level of convolutional interleaver are configured as $(12, 2, \Delta_3=12\times\Delta_1)=(12, 2, 288)$, an input interleaving depth of the 3rd level of convolutional interleaver is $w_2 \times p_2$=12, and an output interleaving depth of the 3rd level of convolutional interleaver is $w_3 \times p_3$=24.

It should be noted that parameters of two levels of convolutional interleavers included in the first convolutional interleaving module may alternatively have another possibility. For example, the parameters of the 1st level of convolu-

tional interleaver are configured as $(w_1, p_1, \Delta_1, 2\Delta_1)=(2, 3, 24, 48)$, and the parameters of the 2nd level of convolutional interleaver are configured as $(w_2, p_2, \Delta_2=5\times\Delta_1)=(6, 2, 120)$.

In a possible implementation, an inner-code encoder applicable to the first convolutional interleaving module shown in Case 1.1 includes but is not limited to a Hamming (128,120) encoder.

Case 1.2: Quantities of symbols input into sub-lanes of the x levels of convolutional interleavers included in the first convolutional interleaving module are the same.

For example, the x levels of convolutional interleavers all include two sub-lanes. Specifically, parameters of the 1st level of convolutional interleaver include $(w_1, 3, \Delta_1)$, parameters of the 2nd level of convolutional interleaver include $(w_2, 2, \Delta_2)$, parameters of the 3rd level of convolutional interleaver include $(w_3, 2, \Delta_3)$, and by analogy, parameters of the xth level of convolutional interleaver include $(w_x, 2, \Delta_x)$.

Delays of two adjacent levels of convolutional interleavers in the x levels of convolutional interleavers satisfy Formula 5 below:

$$\Delta_k = 2 \times \Delta_{k-1} = 2^{k-1} \times \Delta_1 \quad \text{Formula 5}$$

$\Delta_{k-1}$ is a delay of a $(k-1)$th level of interleaver.

Based on this, each level of convolutional interleaver in the x levels of convolutional interleavers includes a delayed sub-lane. In all levels of convolutional interleavers, delays are different, and a delay of a convolutional interleaver of a current level is twice a delay of a convolutional interleaver of a previous level. With reference to Formula 5 above, the parameters of the 1st level of convolutional interleaver include $(w_1, 3, \Delta_1)$, the parameters of the 2nd level of convolutional interleaver include $(w_2, 2, \Delta_2=2\times\Delta_1)$, the parameters of the 3rd level of convolutional interleaver include $(w_3, 2, \Delta_3=4\times\Delta_1)$, and by analogy, the parameters of the xth level of convolutional interleaver include $(w_x, 2, \Delta_x= 2^{x-1} \times \Delta_1)$. It may also be understood as that a delay of the 1st level of convolutional interleaver is $\Delta$ symbols, a delay of the 2nd level of convolutional interleaver is $2\times\Delta$ symbols, a delay of the 3rd level of convolutional interleaver is $4\times\Delta$ symbols, and a length of a delay of the xth level of convolutional interleaver is $2^{x-1}\times\Delta$ symbols.

For example, L=68, the first convolutional interleaving module includes the 1st level of convolutional interleaver and the 2nd level of convolutional interleaver, and the first convolutional interleaving module is any one of the z convolutional interleaving modules. The delay between the two adjacent sub-lanes in the 1st level of convolutional interleaver is 36 symbols, and/or a delay of the 2nd level of convolutional interleaver is 72 symbols. For another example, the first convolutional interleaving module includes the 1st level of convolutional interleaver and the 2nd level of convolutional interleaver. The delay between the two adjacent sub-lanes in the 1st level of convolutional interleaver is 34 symbols, and/or a delay of the 2nd level of convolutional interleaver is 68 symbols. For another example, the first convolutional interleaving module includes the 1st level of convolutional interleaver and the 2nd level of convolutional interleaver. The delay between the two adjacent sub-lanes in the 1st level of convolutional interleaver is 38 symbols, and/or a delay of the 2nd level of convolutional interleaver is 76 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 34 symbols, and/or a delay of the 2nd level of convolutional interleaver is 68 symbols, and/or a delay of the 3rd level of convolutional interleaver is 136 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 68 symbols, and/or a delay of the 2nd level of convolutional interleaver is 136 symbols, and/or a delay of the 3rd level of convolutional interleaver is 272 symbols. For another example, the first convolutional interleaving module includes the 1st level of convolutional interleaver, the 2nd level of convolutional interleaver, and the 3rd level of convolutional interleaver. The delay between the two adjacent sub-lanes in the 1st level of convolutional interleaver is 70 symbols, and/or a delay of the 2nd level of convolutional interleaver is 140 symbols, and/or a delay of the 3rd level of convolutional interleaver is 280 symbols.

For example, L=136, the first convolutional interleaving module includes the 1st level of convolutional interleaver, the 2nd level of convolutional interleaver, and the 3rd level of convolutional interleaver, and the first convolutional interleaving module is any one of the z convolutional interleaving modules. The delay between the two adjacent sub-lanes in the 1st level of convolutional interleaver is 72 symbols, and/or a delay of the 2nd level of convolutional interleaver is 144 symbols, and/or a delay of the 3rd level of convolutional interleaver is 288 symbols.

An example in which the first convolutional interleaving module includes two levels of convolutional interleavers is used to describe parameters configured for each level of convolutional interleaver.

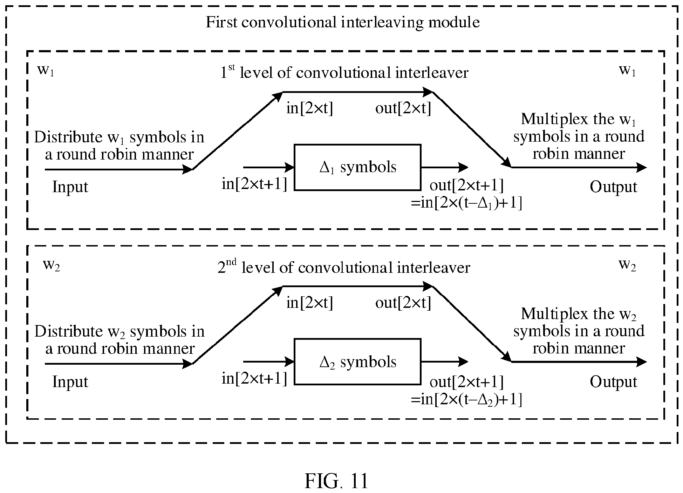

FIG. 11 is a diagram of a structure of another first convolutional interleaving module according to this application. In this example, the first convolutional interleaving module includes a 1st level of convolutional interleaver and a 2nd level of convolutional interleaver. For example, both the 1st level of convolutional interleaver and the 2nd level of convolutional interleaver include two sub-lanes.

k=1, and parameters of the 1st level of convolutional interleaver include ($w_1$, $p_1$, $\Delta_1$). For descriptions of $w_1$, $p_1$, and $\Delta_1$, refer to the foregoing related descriptions. Details are not described herein again. With reference to FIG. 11, the 1st level of convolutional interleaver includes two sub-lanes, $w_1$ symbols are distributed to the two sub-lanes in a round robin manner, a sub-lane 1 is delayed by 0 symbols (that is, the sub-lane 0 is not delayed), and a sub-lane 2 is delayed by $\Delta_1$ symbols. Then, the $w_1$ symbols on the two sub-lanes are multiplexed in a round robin manner, and $w_1$ multiplexed symbols are used as an output of the 1st level of convolutional interleaver.

k=2, and parameters of the 2nd level of convolutional interleaver include ($w_2$, $p_2$, $\Delta_2$). For descriptions of $w_2$, $p_2$, and $\Delta_2$, refer to the foregoing related descriptions. Details are not described herein again. With reference to FIG. 11, the 1st level of convolutional interleaver includes two sub-lanes, $w_2$ symbols are distributed to the two sub-lanes in a round robin manner, a sub-lane 1 is delayed by 0 symbols, and a sub-lane 2 is delayed by $\Delta_2$ symbols. Then, the $w_2$ symbols on the two sub-lanes are multiplexed in a round robin manner, and $w_2$ multiplexed symbols are used as an output of the 2nd level of convolutional interleaver.

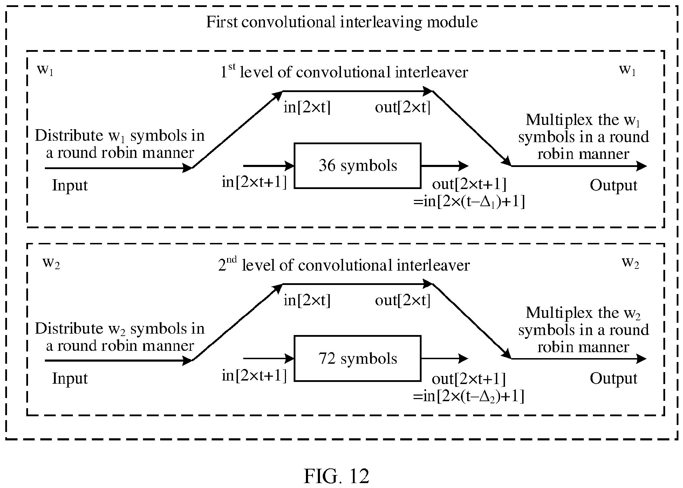

Refer to FIG. 12. $\Delta_1$=36 is used as an example. The parameters of the 1st level of convolutional interleaver are configured as ($w_1$, $p_1$, $\Delta_1$)=(2, 2, 36), and an output interleaving depth of the 1st level of convolutional interleaver is $w_1 \times p_1$=4. The parameters of the 2nd level of convolutional interleaver are configured as ($w_2$, $p_2$, $\Delta_2$=2$\times\Delta_1$)=(4, 2, 72), an output interleaving depth of the 2nd level of convolutional interleaver is $w_2 \times p_2$=8, and an input interleaving depth of the 2nd level of convolutional interleaver is $w_1 \times p_1$=4.

For another example, the parameters of the 1st level of convolutional interleaver are configured as ($w_1$, $p_1$, $\Delta_1$)=(2, 2, 36), the parameters of the 2nd level of convolutional interleaver are configured as ($w_2$, $p_2$, $\Delta_2$=2$\times\Delta_1$)=(4, 2, 72), and the parameters of the 3rd level of convolutional interleaver are configured as ($w_3$, $p_3$, $\Delta_3$)=(8, 2, 144).

In a possible implementation, an inner-code encoder applicable to the first convolutional interleaving module shown in Case 1.2 includes but is not limited to a Hamming (170,160) encoder or a Hamming (180,170) encoder.

Case 2: The quantity of symbols input into the sub-lane of the kth level of convolutional interleaver is greater than the quantity of symbols output from the sub-lane of the kth level of convolutional interleaver.

Further, optionally, quantities of symbols input into sub-lanes of the x levels of convolutional interleavers included in the first convolutional interleaving module are the same, and quantities of symbols output from the sub-lanes of the x levels of convolutional interleavers included in the first convolutional interleaving module are the same. For ease of description of the solution, a quantity of symbols input into a sub-lane of a convolutional interleaver is indicated by w, and a quantity of symbols output from the sub-lane of the convolutional interleaver is indicated by y, where w>y.

It may also be understood as that a size of an input slice data block on a corresponding sub-lane is greater than a size of an output slice data block. For example, an input slice data block on a sub-lane of a 1st level of interleaver is $w_1$ symbols, and an output slice data block is $y_1$ symbols; an input slice data block on a sub-lane of a 2nd level of interleaver is $w_2$ symbols, and an output slice data block is $y_2$ symbols; an input slice data block on a sub-lane of a 3rd level of interleaver is $w_3$ symbols, and an output slice data block is $y_3$ symbols; and by analogy, an input slice data block on a sub-lane of an xth level of interleaver is $w_x$ symbols, and an output slice data block is $y_x$ symbols.

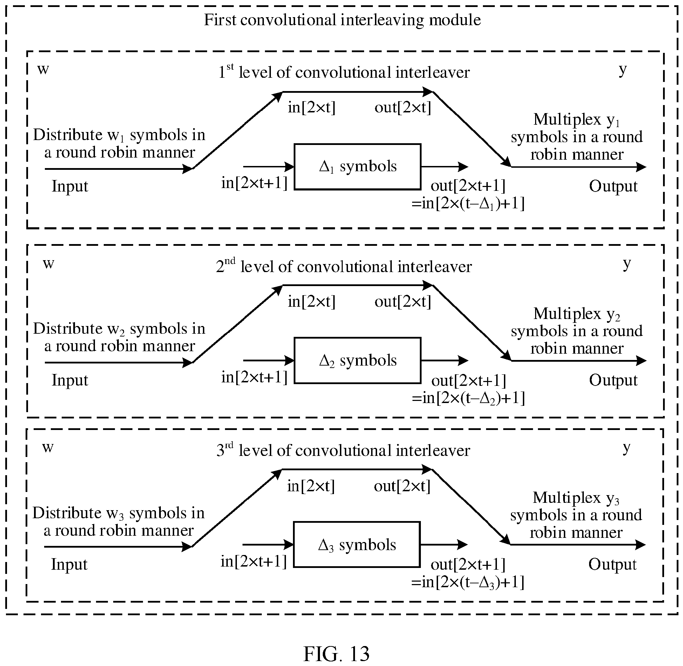

FIG. 13 is a diagram of a structure of still another first convolutional interleaving module according to this application. In this example, the first convolutional interleaving module includes a 1st level of convolutional interleaver, a 2nd level of convolutional interleaver, and a 3rd level of convolutional interleaver, and each level of convolutional interleaver includes two sub-lanes. Quantities of symbols input into sub-lanes of the 1st level of convolutional interleaver, the 2nd level of convolutional interleaver, and the 3rd level of convolutional interleaver are all w, and quantities of symbols input into the sub-lanes of the 1st level of convolutional interleaver, the 2nd level of convolutional interleaver, and the 3rd level of convolutional interleaver are all y, where w is greater than y.

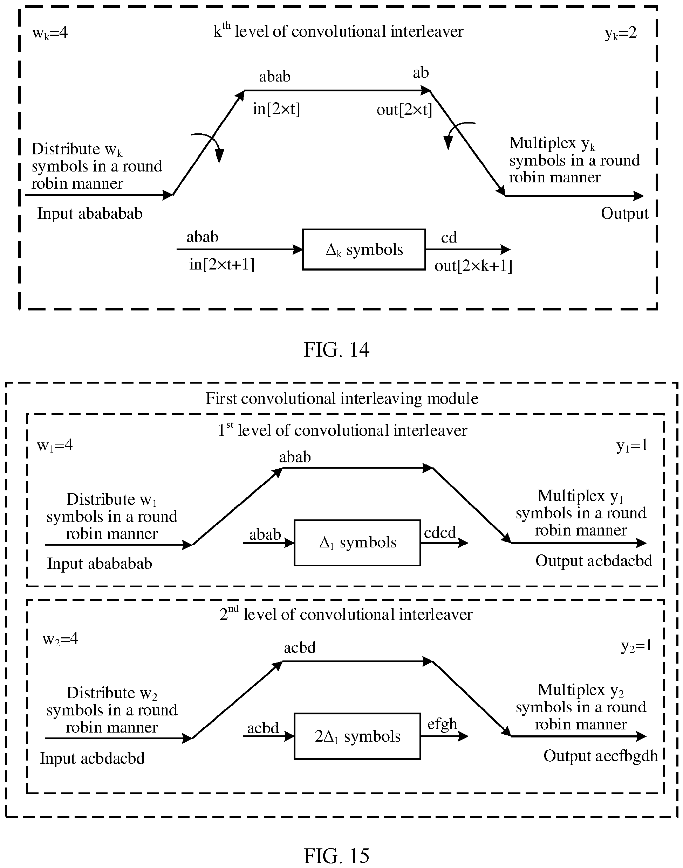

Parameters of a kth level of convolutional interleaver include ($w_k$, $p_k$, $\Delta_k$, $y_k$), where $w_k$ indicates a quantity of symbols input into a sub-lane of the kth level of convolutional interleaver, $p_k$ indicates a quantity of sub-lanes included in the kth level of convolutional interleaver, $\Delta_k$ indicates a delay of the kth level of convolutional interleaver, and $y_k$ indicates a quantity of symbols output from the sub-lane of the kth level of convolutional interleaver. Refer to FIG. 14. An example in which the kth level of convolutional interleaver includes two sub-lanes (a sub-lane 1 and a sub-lane 2) is used. A field abababab is input into the kth level of convolutional interleaver, where a is from a codeword A, and b is from a codeword B. The quantity $w_k$ of symbols input into the sub-lane of the kth level of convolutional interleaver is 4, and $w_k$ symbols are distributed to $p_k$ sub-lanes in a round robin manner. Specifically, a distribution moment $T_1$ of the sub-lane 1 is 2$\times$t, and a distribution moment $T_2$ of the sub-lane 2 is 2$\times$t+1, where t is an integer. It may also be understood as that the $w_k$ symbols are distributed to the sub-lane 1 at a moment 0, and $y_k$ symbols are output from the sub-lane 1; the $w_k$ symbols are distributed to the sub-lane 2 at a moment 1, and $y_k$ symbols are output from the sub-lane 2; the $w_k$ symbols are distributed to the sub-lane 1 at a moment 2, and $y_k$ symbols are output from the sub-lane 1; the $w_k$ symbols are distributed to the sub-lane 2 at a moment 3, and $y_k$ symbols are output from the sub-lane 2; the $w_k$ symbols are distributed to the sub-lane 1 at a moment 4, and $y_k$ symbols are output from the sub-lane 1; the $w_k$ symbols are distributed to the sub-lane 2 at a moment 5, and $y_k$ symbols are output from the sub-lane 2; and the rest can be deduced by analogy. A delay of the sub-lane 1 is 0 symbols, and a delay of the sub-lane 1 is $\Delta_k$ symbols.

Based on this, an input interleaving depth of the first convolutional interleaving module is related to a coding scheme of the PCS and a symbol distribution manner. For details, refer to the foregoing related descriptions. Details are not described herein again. An output interleaving depth of the first convolutional interleaving module is the interleaving depth$\times p_1\times...p_{x-1}\times p_x$, where $p_1$ is a quantity of sub-lanes included in the 1st level of interleaver in the first convolutional interleaving module, $p_{x-1}$ is a quantity of sub-lanes included in an $(x-1)$th level of convolutional interleaver in the first convolutional interleaving module, and $p_x$ is a quantity of sub-lanes included in an $x$th level of convolutional interleaver in the first convolutional interleaving module. It should be noted that an input interleaving depth of the 1st level of convolutional interleaver is the same as the input interleaving depth of the first convolutional interleaving module.

In a possible implementation, a quantity of symbols input into a sub-lane of the $x$th level of convolutional interleaver may be obtained based on the quantity of sub-lanes of the $x$th level of convolutional interleaver and a maximum output interleaving depth of the first convolutional interleaving module. The maximum output interleaving depth of the first convolutional interleaving module is equal to a maximum interleaving depth needed by the inner-code encoder. For the maximum interleaving depth needed by the inner-code encoder, refer to the foregoing related descriptions. Details are not described herein again.

For example, the quantity of symbols input into the sub-lane of the $x$th level of convolutional interleaver is equal to the maximum output interleaving depth of the first convolutional interleaving module divided by the quantity of sub-lanes of the $x$th level of convolutional interleaver. For example, the inner-code encoder uses extended Hamming (128, 120) encoding, and the maximum interleaving depth needed by the inner-code encoder is 120/10=12. This indicates that the maximum output interleaving depth of the first convolutional interleaving module is equal to 12. Further, the quantities w of symbols input into the sub-lanes of the x levels of convolutional interleavers are equal to the maximum output interleaving depth 12 of the first convolutional interleaving module divided by the quantity 2 of sub-lanes of the $x$th level of convolutional interleaver, that is, the quantities w of symbols input into the sub-lanes of the x levels of convolutional interleavers each are 6.

In a possible implementation, the quantities of symbols output from the sub-lanes of the x levels of convolutional interleavers are obtained based on the input interleaving depth of the first convolutional interleaving module.

For example, the quantities of symbols output from the sub-lanes of the x levels of convolutional interleavers are equal to the input interleaving depth of the first convolutional interleaving module; the quantities of symbols output from the sub-lanes of the x levels of convolutional interleavers are equal to 1/2 of the input interleaving depth of the first convolutional interleaving module; or the quantities of symbols output from the sub-lanes of the x levels of convolutional interleavers are equal to 1/4 of the input interleaving depth of the first convolutional interleaving module. For example, the input interleaving depth Num_RS of the first convolutional interleaving module is 2, and the quantities y of symbols output from the sub-lanes of the x levels of convolutional interleavers each are 2 or 1.

The following examples show specific examples of parameters of the first convolutional interleaving module based on Case 2.

In Example A, x=2, $w_1=w_2=4$, $y_1=y_2=1$, and Num_RS=2.

In this example, the first convolutional interleaving module includes two levels of convolutional interleavers (x=2): a 1st level of convolutional interleaver and a 2nd level of convolutional interleaver. Specifically, four parameters of the 1st level of convolutional interleaver are $(w_1, p_1, \Delta_1, y_1)=(4, 2, \Delta, 1)$, and an output interleaving depth of the 1st level of convolutional interleaver is Num_RS$\times p_1=2\times 2=4$; and four parameters of the 2nd level of convolutional interleaver are $(w_2, p_2, \Delta_2, y_2)=(4, 2, 2\times\Delta, 1)$, and an output interleaving depth of the 2nd level of convolutional interleaver is Num_RS$\times p_1\times p_2=2\times 2\times 2=8$.

As shown in FIG. 15, a first field input into the 1st level of convolutional interleaver is eight symbols from the codeword A and the codeword B. A distribution manner of the eight symbols is abababab, and every four (that is, $w_1=w_2=4$) symbols are distributed to the sub-lane 1 and the sub-lane 2 in a round robin manner. Four symbols allocated to the sub-lane 1 are abab, and four symbols allocated to the sub-lane 2 are also abab. A data stream of the sub-lane 2 is delayed by more than L/2 symbols, to ensure that output symbols of the sub-lane 2 are symbols of a second field, that is, cdcd. Then, the first field and the second field on two sub-lanes as the sub-lane 1 and the sub-lane 2 are multiplexed and output in a round robin manner at a granularity of one (that is, $y_1=y_2=1$) symbol, that is, an output field of the 1st level of convolutional interleaver is acbdacbd.

In Example B, x=2, $w_1=w_2=4$, $y_1=y_2=2$, and Num_RS=2.

In this example, the first convolutional interleaving module includes two levels of convolutional interleavers (x=2): a 1st level of convolutional interleaver and a 2nd level of convolutional interleaver. Specifically, four parameters of the 1st level of convolutional interleaver are $(w_1, p_1, \Delta_1, y_1)=(4, 2, \Delta, 2)$, and an output interleaving depth of the 1st level of convolutional interleaver is Num_RS$\times p_1=2\times 2=4$; and four parameters of the 2nd level of convolutional interleaver are $(w_2, p_2, \Delta_2, y_2)=(4, 2, 2\times\Delta, 2)$, and an output interleaving depth of the 2nd level of convolutional interleaver is Num_RS$\times p_1\times p_2=2\times 2\times 2=8$.

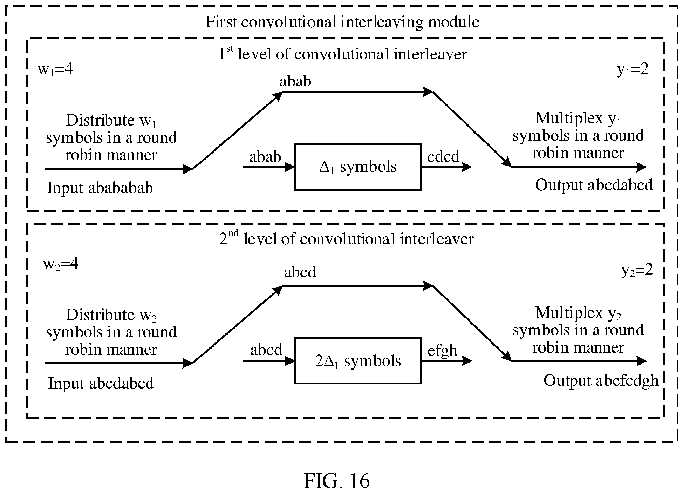

As shown in FIG. 16, a first field input into the 1st level of convolutional interleaver is eight symbols from the codeword A and the codeword B. A distribution manner of the eight symbols is abababab, and every four (that is, $w_1=w_2=4$)

symbols are distributed to the sub-lane 1 and the sub-lane 2 in a round robin manner. Four symbols allocated to the sub-lane 1 are abab, and four symbols allocated to the sub-lane 2 are also abab. A data stream of the sub-lane 2 is delayed by more than L/2 symbols, to ensure that output symbols of the sub-lane 2 are symbols of a second field, that is, cdcd. Then, the first field and the second field on two sub-lanes as the sub-lane 1 and the sub-lane 2 are multiplexed and output in a round robin manner at a granularity of two (that is, $y_1=y_2=2$) symbols, that is, an output field of the 1st level of convolutional interleaver is abcdabcd.

In Example C, x=2, $w_1=w_2=8$, $y_1=y_2=1$, and Num_RS=4.

In this example, the first convolutional interleaving module includes two levels of convolutional interleavers (x=2): a 1st level of convolutional interleaver and a 2nd level of convolutional interleaver. Specifically, four parameters of the 1st level of convolutional interleaver are $(w_1, p_1, \Delta_1, y_1)=(8, 2, 2\times\Delta, 2)$, and an output interleaving depth of the 1st level of convolutional interleaver is Num_RS$\times p_1=4\times 2=8$; and four parameters of the 2nd level of convolutional interleaver are $(w_2, p_2, \Delta_2, y_2)=(8, 2, 4\times\Delta, 2)$, and an output interleaving depth of the 2nd level of convolutional interleaver is Num_RS$\times p_1\times p_2=4\times 2\times 2=16$.

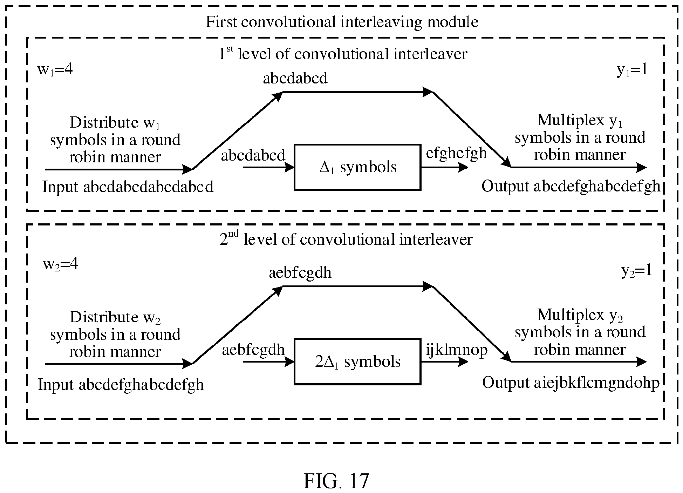

As shown in FIG. 17, a first field input into the 1st level of convolutional interleaver is 16 symbols from the codeword A, the codeword B, a codeword C, and a codeword D, a symbol of the RS codeword A is a symbol a, a symbol of the RS codeword B is a symbol b, a symbol of the RS codeword C is a symbol c, and a symbol of the RS codeword D is a symbol d. Four RS codewords are defined as one group, and a total length of symbols that are of one group of symbols of RS codewords and that are allocated to each PCS lane is L. A distribution manner of the 16 symbols is abcdabcdabcdabcd, and every eight (that is, $w_1=w_2=8$) symbols are distributed to the sub-lane 1 and the sub-lane 2 in a round robin manner. Eight symbols allocated to the sub-lane 1 are abcdabcd, and eight symbols allocated to the sub-lane 2 are also abcdabcd. A data stream of the sub-lane 2 is delayed by more than L/2 symbols, to ensure that output symbols of the sub-lane 2 are symbols of a second field, that is, efghefgh. Then, the first field and the second field on two sub-lanes as the sub-lane 1 and the sub-lane 2 are multiplexed and output in a round robin manner at a granularity of one (that is, $y_1=y_2=1$) symbol, that is, an output field of the 1st level of convolutional interleaver is abcdefghabcdefgh.

In Example D, x=2, $w_1=w_2=6$, $y_1=y_2=2$, and Num_RS=2.

In this example, the first convolutional interleaving module includes two levels of convolutional interleavers (x=2): a 1st level of convolutional interleaver and a 2nd level of convolutional interleaver. Specifically, four parameters of the 1st level of convolutional interleaver are $(w_1, p_1, \Delta_1, y_1)=(6, 3, \Delta, 2)$, and an output interleaving depth of the 1st level of convolutional interleaver is Num_RS$\times p_1=2\times 3=6$; and four parameters of the 2nd level of convolutional interleaver are $(w_2, p_2, \Delta_2, y_2)=(6, 2, 2\times\Delta, 2)$, and an output interleaving depth of the 2nd level of convolutional interleaver is Num_RS$\times p_1\times p_2=2\times 3\times 2=12$.

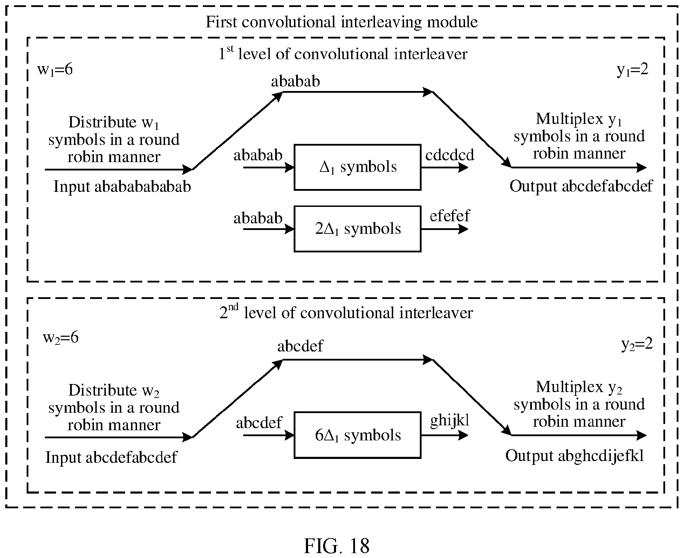

As shown in FIG. 18, a first field input into the 1st level of convolutional interleaver is 12 symbols from the codeword A and the codeword B, and a distribution manner of the 12 symbols is abababababab. In the 1st level of convolutional interleaver, every six (that is, $w_1=w_2=6$) symbols are distributed to the sub-lane 1, the sub-lane 2, and the sub-lane 3 in a round robin manner. Six symbols allocated to the sub-lane 1 are ababab, and six symbols allocated to the sub-lane 2 are also ababab. A data stream of the sub-lane 2 is delayed by more than L/2 symbols, to ensure that output symbols of the sub-lane 2 are symbols of a second field, that is, cdcdcd. Then, the first field and the second field on two sub-lanes as the sub-lane 1 and the sub-lane 2 are multiplexed and output in a round robin manner at a granularity of two (that is, $y_1=y_2=2$) symbols, that is, an output field of the 1st level of convolutional interleaver is abcdefabcdef.

In Example G, x=3, $w_1=w_2=w_3=8$, $y_1=y_2=y_3=1$, and Num_RS=2.

In this example, the first convolutional interleaving module includes three levels of cascaded convolutional interleavers (x=3): a 1st level of convolutional interleaver, a 2nd level of convolutional interleaver, and a 3rd level of convolutional interleaver. Specifically, four parameters of the 1st level of convolutional interleaver are $(w_1, p_1, \Delta_1, y_1)=(8, 2, \Delta, 1)$, and an output interleaving depth of the 1st level of convolutional interleaver is Num_RS$\times p_1=2\times 2=4$; four parameters of the 2nd level of convolutional interleaver are $(w_2, p_2, \Delta_2, y_2)=(8, 2, 2\times\Delta, 1)$, and an output interleaving depth of the 2nd level of convolutional interleaver is Num_RS$\times p_1\times p_2=2\times 2\times 2=8$; and four parameters of the 3rd level of convolutional interleaver are $(w_3, p_3, \Delta_3, y_3)=(8, 2, 4\times\Delta, 1)$, and an output interleaving depth of the 3rd level of convolutional interleaver is Num_RS$\times p_1\times p_2\times p_3=2\times 2\times 2\times 2=16$.

In Example E, x=3, $w_1=w_2=w_3=8$, $y_1=y_2=y_3=2$, and Num_RS=2.

In this example, the first convolutional interleaving module includes three levels of cascaded convolutional interleavers (x=3): a 1st level of convolutional interleaver, a 2nd level of convolutional interleaver, and a 3rd level of convolutional interleaver. Specifically, four parameters of the 1st level of convolutional interleaver are $(w_1, p_1, \Delta_1, y_1)=(8, 2, \Delta, 2)$, and an output interleaving depth of the 1st level of convolutional interleaver is Num_RS$\times p_1=2\times 2=4$; four parameters of the 2nd level of convolutional interleaver are $(w_2, p_2, \Delta_2, y_2)=(8, 2, 2\times\Delta, 2)$, and an output interleaving depth of the 2nd level of convolutional interleaver is Num_RS$\times p_1\times p_2=8$; and four parameters of the 3rd level of convolutional interleaver are $(w_3, p_3, \Delta_3, y_3)=(8, 2, 4\times\Delta, 2)$, and an output interleaving depth of the 3rd level of convolutional interleaver is Num_RS$\times p_1\times p_2\times p_3=2\times 2\times 2\times 2=16$.

It should be noted that each of the x levels of convolutional interleavers may include three or more sub-lanes.

In Example F, x=3, $w_1=w_2=w_3=4$, $y_1=y_2=y_3=1$, and Num_RS=1.

In this example, the first convolutional interleaving module includes three levels of cascaded convolutional interleavers (x=3): a 1st level of convolutional interleaver, a 2nd level of convolutional interleaver, and a 3rd level of convolutional interleaver. Four parameters of the 1st level of convolutional interleaver are $(w_1, p_1, \Delta_1, y_1)=(4, 2, \Delta/2, 1)$, and an output interleaving depth of the 1st level of convolutional interleaver is Num_RS$\times p_1=1\times 2=2$; four parameters of the 2nd level of convolutional interleaver are $(w_2, p_2, \Delta_2, y_2)=(4, 2, \Delta, 1)$, and an output interleaving depth of the 2nd level of convolutional interleaver is Num_RS$\times p_1\times p_2=1\times 2\times 2=4$; and four parameters of the 3rd level of convolutional interleaver are $(w_3, p_3, \Delta_3, y_3)=(4, 2, 2\times\Delta, 1)$, and an output interleaving depth of the 3rd level of convolutional interleaver is Num_RS$\times p_1\times p_2\times p_3=1\times 2\times 2\times 2=8$.

In a possible implementation, the data transmission apparatus may further include a mapping module. The mapping module is configured to map data encoded by an inter-code encoding module, and a processing granularity may be 1 bit, 2 bits, 4 bits, 8 bits, or the like.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

"A plurality of" in this application means two or more than two. The term "and/or" describes an association relationship between associated objects, and indicates that three relationships may exist. For example, A and/or B may indicate the following three cases: Only A exists, both A and B exist, and only B exists. A and B may be singular or plural. In text descriptions of this application, the character "/" generally indicates an "or" relationship between associated objects. In a formula of this application, the character "/" indicates a "division" relationship between associated objects. In addition, in this application, the term "for example" indicates giving an example, an illustration, or a description. Any embodiment or design scheme described as an "example" in this application should not be explained as being more preferred or having more advantages than another embodiment or design scheme. Alternatively, it may be understood as that the term "example" is used to present a concept in a specific manner, and does not constitute a limitation on this application.

It may be understood that, in this application, various numeric numbers are distinguished merely for ease of description and are not used to limit the scope of embodiments of this application. Sequence numbers of the foregoing processes do not mean execution sequences, and the execution sequences of the processes should be determined based on functions and internal logic of the processes. The terms "first", "second", and the like are used to distinguish between similar objects, but do not necessarily indicate a specific order or sequence. In addition, the terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data transmission apparatus, comprising z physical coding sublayer PCS lanes and z convolutional interleaving modules, wherein one convolutional interleaving module corresponds to one PCS lane, the convolutional interleaving module comprises x levels of cascaded convolutional interleavers, x is an integer greater than 1, and z is a positive integer;

   the PCS lane is configured to receive a first data stream from a PCS, wherein one first data stream corresponds to one PCS lane; and
   the convolutional interleaving module is configured to perform interleaving processing on a first data stream from a corresponding PCS lane, to obtain a second data stream, wherein an interleaving depth of the second data stream is related to a quantity of input bits of an inner-code encoder.

2. The apparatus according to claim 1, wherein the convolutional interleaving module is specifically configured to:

   perform interleaving processing on the first data stream from the corresponding PCS lane based on a received indication signal, wherein
   the indication signal indicates to bypass at least one level of convolutional interleaver in the z convolutional interleaving modules; or
   the indication signal indicates to bypass a jth level of convolutional interleaver in an ith convolutional interleaving

module in the z convolutional interleaving modules, wherein i is an integer less than z, and j is an integer less than x.

3. The apparatus according to claim 2, wherein the apparatus further comprises a management data input/output MDIO interface, and the indication signal comprises a value of an MDIO control bit; and
the MDIO interface is configured to receive first information, wherein the first information comprises the value of the MDIO control variable, and the MDIO control variable is mapped to a control variable of the x levels of convolutional interleavers.

4. The apparatus according to claim 2, wherein the apparatus further comprises an attachment unit interface AUI, and the indication signal comprises a first preset sequence or a second preset sequence; and
the AUI is configured to: receive an alignment marker AM sequence from the corresponding PCS lane, wherein the AM sequence comprises the first preset sequence; or receive the second preset sequence from the corresponding PCS lane.

5. The apparatus according to any one of claims 1 to 4, wherein a quantity of symbols input into a sub-lane of a $k^{th}$ level of convolutional interleaver is equal to a quantity of symbols output from the sub-lane of the $k^{th}$ level of convolutional interleaver, the $k^{th}$ level of convolutional interleaver is any one of x convolutional interleavers in a first convolutional interleaving module, the first convolutional interleaving module is any one of the z convolutional interleaving modules, and k is a positive integer less than or equal to x.

6. The apparatus according to claim 5, wherein an input interleaving depth of the first convolutional interleaving module is related to a coding scheme of the PCS and a symbol distribution manner; and

an output interleaving depth of the first convolutional interleaving module is $w_x \times p_x$, wherein $w_x$ is a quantity of symbols input into a sub-lane of an $x^{th}$ level of convolutional interleaver in the first convolutional interleaving module, and $p_x$ is a quantity of sub-lanes comprised in the $x^{th}$ level of convolutional interleaver in the first convolutional interleaving module.

7. The apparatus according to claim 6, wherein k is a positive integer greater than 1 and less than or equal to x, an input interleaving depth of the $k^{th}$ level of convolutional interleaver is $w_{k-1} \times p_{k-1}$, and an output interleaving depth of the $k^{th}$ level of convolutional interleaver is $w_k \times p_k$, wherein $w_k$ is the quantity of symbols input into the sub-lane of the $k^{th}$ level of convolutional interleaver, $p_k$ is a quantity of sub-lanes comprised in the $k^{th}$ level of convolutional interleaver, $w_{k-1}$ is a quantity of symbols input into a sub-lane of a $(k-1)^{th}$ level of convolutional interleaver, and $p_{k-1}$ is a quantity of sub-lanes comprised in the $(k-1)^{th}$ level of convolutional interleaver; and
an input interleaving depth of a $1^{st}$ level of convolutional interleaver in the first convolutional interleaving module is equal to the input interleaving depth of the first convolutional interleaving module.

8. The apparatus according to any one of claims 1 to 7, wherein quantities of sub-lanes of the x levels of convolutional interleavers comprised in the first convolutional interleaving module are different, and the first convolutional interleaving module is any one of the z convolutional interleaving modules.

9. The apparatus according to claim 8, wherein a quantity of sub-lanes of the $1^{st}$ level of convolutional interleaver comprised in the first convolutional interleaving module is different from quantities of sub-lanes of (x-1) levels of convolutional interleavers other than the $1^{st}$ level of convolutional interleaver comprised in the first convolutional interleaving module, and the quantities of sub-lanes of the (x-1) levels of convolutional interleavers other than the $1^{st}$ level of convolutional interleaver comprised in the first convolutional interleaving module are the same.

10. The apparatus according to claim 8 or 9, wherein the first convolutional interleaving module comprises the $1^{st}$ level of convolutional interleaver and a $2^{nd}$ level of convolutional interleaver, and the first convolutional interleaving module is any one of the z convolutional interleaving modules; and

a delay between two adjacent sub-lanes in the $1^{st}$ level of convolutional interleaver is 24 symbols; and/or
a delay of the $2^{nd}$ level of convolutional interleaver is 120 symbols.

11. The apparatus according to any one of claims 1 to 7, wherein quantities of sub-lanes comprised in the x levels of convolutional interleavers comprised in the first convolutional interleaving module are the same, and the first convolutional interleaving module is any one of the z convolutional interleaving modules.

12. The apparatus according to claim 11, wherein the first convolutional interleaving module comprises the 1st level of convolutional interleaver and a 2nd level of convolutional interleaver, and the first convolutional interleaving module is any one of the z convolutional interleaving modules; and

a delay between two adjacent sub-lanes in the 1st level of convolutional interleaver is 36 symbols; and/or
a delay of the 2nd level of convolutional interleaver is 72 symbols; and/or
a delay of a 3rd level of convolutional interleaver is 144 symbols.

13. The apparatus according to any one of claims 1 to 4, wherein quantities of symbols input into sub-lanes of x levels of convolutional interleavers comprised in a first convolutional interleaving module are all the same, quantities of symbols output from the sub-lanes of the x levels of convolutional interleavers comprised in the first convolutional interleaving module are all the same, and a quantity of symbols input into a sub-lane of a $k^{th}$ level of convolutional interleaver is greater than a quantity of symbols output from the sub-lane of the $k^{th}$ level of convolutional interleaver, wherein

the $k^{th}$ level of convolutional interleaver is any one of the x convolutional interleavers in the first convolutional interleaving module, the first convolutional interleaving module is any one of the z convolutional interleaving modules, and k is a positive integer less than or equal to x.

14. The apparatus according to claim 13, wherein an input interleaving depth of the first convolutional interleaving module is related to a coding scheme of the PCS and a symbol distribution manner; and
an output interleaving depth of the first convolutional interleaving module is the input interleaving depth$\times p_1 \times ... p_{x-1} \times p_x$, wherein $p_1$ is a quantity of sub-lanes comprised in a 1st level of convolutional interleaver in the first convolutional interleaving module, $p_{x-1}$ is a quantity of sub-lanes comprised in an $(x-1)^{th}$ level of convolutional interleaver in the first convolutional interleaving module, and $p_x$ is a quantity of sub-lanes comprised in an $x^{th}$ level of convolutional interleaver in the first convolutional interleaving module.

15. The apparatus according to claim 13 or 14, wherein a quantity of symbols input into a sub-lane of the $x^{th}$ level of convolutional interleaver is obtained based on the quantity of sub-lanes of the $x^{th}$ level of convolutional interleaver and a maximum output interleaving depth of the first convolutional interleaving module; and
a quantity of symbols output from the sub-lane of the $x^{th}$ level of convolutional interleaver is obtained based on the input interleaving depth of the first convolutional interleaving module.

16. The apparatus according to claim 15, wherein the quantity of symbols input into the sub-lane of the $x^{th}$ level of convolutional interleaver is equal to the maximum output interleaving depth of the first convolutional interleaving module divided by the quantity of sub-lanes of the $x^{th}$ level of convolutional interleaver; and
the quantity of symbols output from the sub-lane of the $x^{th}$ level of convolutional interleaver is equal to the input interleaving depth of the first convolutional interleaving module.

17. The apparatus according to any one of claims 13 to 15, wherein the quantities of symbols input into the sub-lanes of the x levels of convolutional interleavers and the quantities of symbols output from the sub-lanes of the x levels of convolutional interleavers are any one of the following:

the quantities of symbols input into the sub-lanes of the x levels of convolutional interleavers each are 8, and the quantities of symbols output from the sub-lanes of the x levels of convolutional interleavers each are 2;
the quantities of symbols input into the sub-lanes of the x levels of convolutional interleavers each are 6, and the quantities of symbols output from the sub-lanes of the x levels of convolutional interleavers each are 2;
the quantities of symbols input into the sub-lanes of the x levels of convolutional interleavers each are 4, and the quantities of symbols output from the sub-lanes of the x levels of convolutional interleavers each are 2;
the quantities of symbols input into the sub-lanes of the x levels of convolutional interleavers each are 8, and the quantities of symbols output from the sub-lanes of the x levels of convolutional interleavers each are 1;
the quantities of symbols input into the sub-lanes of the x levels of convolutional interleavers each are 6, and the quantities of symbols output from the sub-lanes of the x levels of convolutional interleavers each are 1; or
the quantities of symbols input into the sub-lanes of the x levels of convolutional interleavers each are 4, and the quantities of symbols output from the sub-lanes of the x levels of convolutional interleavers each are 1.

Core
layer

Aggregation
layer

Access
layer

Server

FIG. 1a

FIG. 1b

FIG. 2a

Optical module

| PMD layer |
| PMA layer |
| Inner (Inner)-FEC layer |

FIG. 2b

Host

| PCS |
| Inner (Inner)-FEC layer |

FIG. 3

Optical module

| PMD layer |
| PMA layer |
| Unit with a function of an inner (Inner)-FEC layer |

MDIO interface

AUI

Host

| PCS |
| Inner (Inner)-FEC layer |

FIG. 4

FIG. 5

Indication
signal

Data transmission apparatus

PCS lane
1

| 1st level of convolutional interleaver | 2nd level of convolutional interleaver | 3rd level of convolutional interleaver |

PCS lane
2

| 1st level of convolutional interleaver | 2nd level of convolutional interleaver | 3rd level of convolutional interleaver |

PCS lane
z

| 1st level of convolutional interleaver | 2nd level of convolutional interleaver | 3rd level of convolutional interleaver |

FIG. 6a

FIG. 6b

FIG. 7a

FIG. 7b

FIG. 8

FIG. 9

First convolutional interleaving module

1st level of convolutional interleaver

$w_1$

$w_1$

ab
in[3×t]

ab
out[3×t]

abababababab
Input

ab
in[3×t+1]

24 symbols

cd
out[3×t+1]
=in[3×(t–$\Delta_1$)+1]

abcdefabcdef
Output

ab
in[3×t+2]

48 symbols

ef
out[3×t+2]
=in[3×(t–2$\Delta_1$)+1]

2nd level of convolutional interleaver

$w_2$

$w_2$

abcdef
in[2×t]

out[2×t]

abcdefabcdef
Input

abcdef
in[2×t+1]

144 symbols

ghijkl
out[2×t+1]
=in[2×(t–$\Delta_2$)+1]

abcdefghijkl
Output

3rd level of convolutional interleaver

$w_3$

$w_3$

abcdefghijkl
in[2×t]

out[2×t]

abcdefghijkl
Input

abcdefghijkl
in[2×t+1]

288
symbols

mnopqrstuvwy
out[2×t+1]
=in[2×(t–$\Delta_3$)+1]

abcdefghijklmnopqrstuvwy
Output

FIG. 10

FIG. 11

First convolutional interleaving module

$w_1$ — 1st level of convolutional interleaver — $w_1$

in[2×t]     out[2×t]

Distribute $w_1$ symbols in a round robin manner

Multiplex the $w_1$ symbols in a round robin manner

Input

in[2×t+1]   36 symbols   out[2×t+1]
=in[2×(t−$\Delta_1$)+1]

Output

$w_2$ — 2nd level of convolutional interleaver — $w_2$

in[2×t]     out[2×t]

Distribute $w_2$ symbols in a round robin manner

Multiplex the $w_2$ symbols in a round robin manner

Input

in[2×t+1]   72 symbols   out[2×t+1]
=in[2×(t−$\Delta_2$)+1]

Output

FIG. 12

First convolutional interleaving module

w                    1$^{st}$ level of convolutional interleaver                    y

in[2×t]        out[2×t]

Multiplex $y_1$
symbols in a round
robin manner

Distribute $w_1$ symbols in
a round robin manner

$\Delta_1$ symbols

in[2×t+1]

Input

out[2×t+1]
=in[2×(t–$\Delta_1$)+1]

Output

w                    2$^{nd}$ level of convolutional interleaver                    y

in[2×t]        out[2×t]

Multiplex $y_2$
symbols in a round
robin manner

Distribute $w_2$ symbols in
a round robin manner

$\Delta_2$ symbols

in[2×t+1]

Input

out[2×t+1]
=in[2×(t–$\Delta_2$)+1]

Output

w                    3$^{rd}$ level of convolutional interleaver                    y

in[2×t]        out[2×t]

Multiplex $y_3$
symbols in a round
robin manner

Distribute $w_3$ symbols in
a round robin manner

$\Delta_3$ symbols

in[2×t+1]

Input

out[2×t+1]
=in[2×(t–$\Delta_3$)+1]

Output

FIG. 13

$w_k=4$      $k^{th}$ level of convolutional interleaver      $y_k=2$

abab      ab

in[2×t]      out[2×t]

Distribute $w_k$ symbols in a round robin manner

Input abababab

Multiplex $y_k$ symbols in a round robin manner

Output

abab

in[2×t+1]

$\Delta_k$ symbols

cd

out[2×k+1]

FIG. 14

First convolutional interleaving module

$1^{st}$ level of convolutional interleaver

$w_1=4$      $y_1=1$

abab

Distribute $w_1$ symbols in a round robin manner

Input abababab

abab   $\Delta_1$ symbols   cdcd

Multiplex $y_1$ symbols in a round robin manner

Output acbdacbd

$2^{nd}$ level of convolutional interleaver

$w_2=4$      $y_2=1$

acbd

Distribute $w_2$ symbols in a round robin manner

Input acbdacbd

acbd   $2\Delta_1$ symbols   efgh

Multiplex $y_2$ symbols in a round robin manner

Output aecfbgdh

FIG. 15

FIG. 16

FIG. 17

First convolutional interleaving module

1st level of convolutional interleaver

$w_1=6$

$y_1=2$

ababab

Distribute $w_1$
symbols in a round
robin manner

Multiplex $y_1$
symbols in a round
robin manner

ababab $\to$ | $\Delta_1$ symbols | $\to$ cdcdcd

Input ababababab

Output abcdefabcdef

ababab $\to$ | $2\Delta_1$ symbols | $\to$ efefef

2nd level of convolutional interleaver

$w_2=6$

$y_2=2$

abcdef

Distribute $w_2$
symbols in a round
robin manner

Multiplex $y_2$
symbols in a round
robin manner

abcdef $\to$ | $6\Delta_1$ symbols | $\to$ ghijkl

Input abcdefabcdef

Output abghcdijefkl

FIG. 18

## INTERNATIONAL SEARCH REPORT

International application No.

**PCT/CN2023/093000**

**A.    CLASSIFICATION OF SUBJECT MATTER**

H04L1/00(2006.01)i

According to International Patent Classification (IPC) or to both national classification and IPC

**B.    FIELDS SEARCHED**

Minimum documentation searched (classification system followed by classification symbols)

IPC： H04L H03M H04B

Documentation searched other than minimum documentation to the extent that such documents are included in the fields searched

Electronic data base consulted during the international search (name of data base and, where practicable, search terms used)

CNKI; CJFD; IEEE; VCN; VEN; CNTXT; ENTXT; ENTXTC: 多, 卷积, 交织, 通道, pcs, 子通道, 多路, 深度, 前向纠错编码, 编码, code, FEC, channel, path, several, mutipl+, interleaver, convolutional

**C.    DOCUMENTS CONSIDERED TO BE RELEVANT**

| Category* | Citation of document, with indication, where appropriate, of the relevant passages | Relevant to claim No. |
|---|---|---|
| A | WO 2022088709 A1 (HUAWEI TECHNOLOGIES CO., LTD.) 05 May 2022 (2022-05-05) claims 1-17, description, paragraphs 81-415, and figures 2-12 | 1-17 |
| A | CA 2243013 A1 (BINGEMAN, M. et al.) 14 January 2000 (2000-01-14) entire document | 1-17 |
| A | US 2006291571 A1 (DIVSALAR, D. et al.) 28 December 2006 (2006-12-28) entire document | 1-17 |
| A | US 2010287453 A1 (TELEFONAKTIEBOLAGET LM ERICSSON (PUBL)) 11 November 2010 (2010-11-11) entire document | 1-17 |
| A | US 2013238962 A1 (TEXAS INSTRUMENTS INCORPORATED) 12 September 2013 (2013-09-12) entire document | 1-17 |
| A | US 2016173233 A1 (SONY CORPORATION) 16 June 2016 (2016-06-16) entire document | 1-17 |

[✓] Further documents are listed in the continuation of Box C.    [✓] See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 July 2023** | **21 July 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/093000** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2021288672 A1 (INPHI CORPORATION) 16 September 2021 (2021-09-16)<br>entire document | 1-17 |

Form PCT/ISA/210 (second sheet) (July 2022)

| INTERNATIONAL SEARCH REPORT | | International application No. |
|---|---|---|
| Information on patent family members | | **PCT/CN2023/093000** |

| Patent document cited in search report | | | Publication date (day/month/year) | Patent family member(s) | | | Publication date (day/month/year) |
|---|---|---|---|---|---|---|---|
| WO | 2022088709 | A1 | 05 May 2022 | CN | 114430278 | A | 03 May 2022 |
| CA | 2243013 | A1 | 14 January 2000 | None | | | |
| US | 2006291571 | A1 | 28 December 2006 | None | | | |
| US | 2010287453 | A1 | 11 November 2010 | JP | 2012517138 | A | 26 July 2012 |
| | | | | EP | 2392074 | A1 | 07 December 2011 |
| | | | | WO | 2010087776 | A1 | 05 August 2010 |
| US | 2013238962 | A1 | 12 September 2013 | US | 2016013812 | A1 | 14 January 2016 |
| US | 2016173233 | A1 | 16 June 2016 | US | 2018159661 | A1 | 07 June 2018 |
| | | | | KR | 20230003274 | A | 05 January 2023 |
| | | | | KR | 20170097034 | A | 25 August 2017 |
| | | | | US | 2017063494 | A1 | 02 March 2017 |
| | | | | WO | 2016096766 | A1 | 23 June 2016 |
| | | | | MX | 2017006311 | A | 21 August 2017 |
| | | | | CA | 2969922 | A1 | 23 June 2016 |
| | | | | GB | 2533308 | A | 22 June 2016 |
| | | | | GB | 2533438 | A | 22 June 2016 |
| | | | | CN | 107005353 | A | 01 August 2017 |
| US | 2021288672 | A1 | 16 September 2021 | US | 2022302930 | A1 | 22 September 2022 |
| | | | | DE | 102021202440 | A1 | 16 September 2021 |
| | | | | CN | 113395134 | A | 14 September 2021 |

Form PCT/ISA/210 (patent family annex) (July 2022)

**REFERENCES CITED IN THE DESCRIPTION**

**Patent documents cited in the description**

• CN 202210731905